(19)

Europäisches Patentamt
European Patent Office
Office européen des brevets

(11) **EP 2 629 123 B1**

(12) **EUROPEAN PATENT SPECIFICATION**

(45) Date of publication and mention
of the grant of the patent:
**07.07.2021 Bulletin 2021/27**

(51) Int Cl.:
***G01V 99/00*** *(2009.01)*

(21) Application number: **13156031.0**

(22) Date of filing: **20.02.2013**

(54) **Simulation model optimization**

Simulationsmodelloptimierung

Optimisation d'un modèle de simulation

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.02.2012 US 201261600921 P
18.02.2013 US 201313769658**

(43) Date of publication of application:
**21.08.2013 Bulletin 2013/34**

(73) Proprietors:
- **Services Petroliers Schlumberger SA
  75007 Paris (FR)**
  Designated Contracting States:
  **FR**
- **Schlumberger Holdings Limited
  Road Town, Tortola 1110 (VG)**
  Designated Contracting States:
  **GB NL**
- **SCHLUMBERGER TECHNOLOGY B.V.
  2514 JG The Hague (NL)**
  Designated Contracting States:
  **AL BG CZ DE DK GR HU IE IT LT NO PL RO SI SK
  TR**
- **Prad Research And Development Limited
  Tortola 1110 (VG)**
  Designated Contracting States:
  **AT BE CH CY EE ES FI HR IS LI LU LV MC MK MT
  PT RS SE SM**

(72) Inventors:
- **Fuchs, Thomas
  52134 Herzogenrath (DE)**
- **Fuecker, Michael
  52428 Julich (DE)**
- **Kauerauf, Armin
  52074 Aachen (DE)**
- **Kleine, Adrian
  52072 Aachen (DE)**

(74) Representative: **Schlumberger Intellectual
Property Department
Parkstraat 83
2514 JG Den Haag (NL)**

(56) References cited:
**US-A1- 2009 265 152**

- **Hantschel and Kauerauf: "Fundamentals of Basin
  and Petroleum Systems Modeling", 9 April 2009
  (2009-04-09), Springer, XP002755407, ISBN:
  978-3-540-72317-2 pages
  91-94,287-290,389-396,403, DOI:
  10.1007/978-3-540-72318-9, * page 91 - page 94 *
  * page 287 - page 290 * * page 390 - page 393 ***
- **Hantschel, Kauerauf and Wygrala: "Finite
  element analysis and ray tracing modeling of
  petroleum migration", Marine and Petroleum
  Geology, vol. 17, no. 7 1 August 2000 (2000-08-01),
  pages 815-820, XP002755406, ISSN: 0264-8172,
  DOI: 10.1016/S0264-8172(99)00061-6 Retrieved
  from the Internet:
  URL:http://ac.els-cdn.com/S026481729900061
  6/1-s2.0-S0264817299000616-main.pdf?_tid=d
  9caec04-e9b7-11e5-b98a-00000aab0f26&acdnat
  =1457941335_2b7165294ee6c76a3a19e7266c55
  dc a1 [retrieved on 2016-03-18]**
- **None**

## Description

### BACKGROUND

Sedimentary basins can be modeled using numerical techniques such as the finite element method. Such modeling can include developing a model based in part on a finite element grid that defines finite elements that represent and discretize a physical space (e.g., at least a portion of a sedimentary basin). In turn, the finite element method may be performed using the model to provide simulation results (e.g., simulating physical phenomena associated with a sedimentary basin). Arriving at a suitable model may be an arduous process as present day values for properties of a sedimentary basin may not be known with reasonable certainty. Various technologies, techniques, etc., described herein can provide for finite element grid adjustment, for example, for purposes of optimizing a model of a sedimentary basin.

### SUMMARY

There is provided a method and system according to the appended claims 1 and 11, respectively.

### BRIEF DESCRIPTION OF THE DRAWINGS

Features and advantages of the described implementations can be more readily understood by reference to the following description taken in conjunction with the accompanying drawings.

Fig. 1 illustrates an example system that includes various components for simulating a geological environment;
Fig. 2 illustrates an example of petroleum systems modeling;
Fig. 3 illustrates examples of equations that may be used in petroleum systems modeling;
Fig. 4 illustrates an example of layer compaction and an example of a process for calculating present day properties for a multilayer model;
Fig. 5 illustrates an example of a method;
Fig. 6 illustrates an example of a method;
Fig. 7 illustrates examples of finite element grids for different grid resolutions;
Fig. 8 illustrates examples of finite element grids for different grid resolutions;
Fig. 9 illustrates an example of a method;
Fig. 10 illustrates an example of a system and an example of a graphical user interface that includes controls for grid adjustment for a method that includes backstripping and forward simulation; and
Fig. 11 illustrates example components of a system and a networked system.

### DETAILED DESCRIPTION

The following description includes the best mode presently contemplated for practicing the described implementations. This description is not to be taken in a limiting sense, but rather is made merely for the purpose of describing the general principles of the implementations. The scope of the described implementations should be ascertained with reference to the issued claims.

In basin and petroleum systems modeling quantities such as temperature, pressure and porosity distributions within the sediments may be modeled by solving partial differential equations (PDEs) using a finite element method. Modeling may also model geometry with respect to time, for example, to account for changes stemming from geological events (e.g., deposition of material, erosion of material, shifting of material, etc.).

Various techniques for modeling of temperature, pressure, porosity, and geometry in basin and petroleum systems are, for example, described in a text by Hantschel et al. (2009), entitled "Fundamentals of Basin and Petroleum Systems Modeling". A commercially available modeling framework marketed as the PETROMOD® framework (Schlumberger Limited, Houston, Texas) includes features for input of various types of information (e.g., seismic, well, geological, etc.) to model evolution of a sedimentary basin. Such a framework may provide for predicting if, and how, a reservoir has been charged with hydrocarbons, including source and timing of hydrocarbon generation, migration routes, quantities, hydrocarbon type, etc. Such a framework may include features for performing a backstripping technique as well as an associated forward modeling technique. As an example, a sedimentary basin may be modeled using a numerical technique that includes discretization of a spatial domain (e.g., 1D, 2D or 3D) via nodes and representing phenomena germane to that domain through sets of equations interconnected via segments or elements defined with respect to the nodes.

As an example, where the finite element method (FEM) is applied, a set of nodes may define a finite element grid. Details of various types of finite element method techniques may be found, for example, in a text by Zienkiewicz and Taylor (1984), entitled "The Finite Element Method Set". For example, the text by Zienkiewicz and Taylor describes steady-state and time simulation techniques. As an example, where time is involved, numerical simulation may include another type of numerical technique such as a finite difference technique (e.g., discretization in time) in addition to the FEM, for example, the FEM may be applied to a spatial domain and a finite difference technique may be applied to a time domain. In such an example, the FEM may solve for unknowns at discrete points in time, for example, while time marches forwards or backwards according to a finite difference approach. As another example, consider that the FEM may be applied to a time domain (e.g., as well as a spatial domain). Further, as an example, a FEM technique may be applied in a so-called "inverse" manner where unknowns represent spatial positions for nodes of a finite element grid (e.g., consider specifying isotherms and solving for the locations of the isotherms, specifying a boundary and solving for the location of that boundary, etc.).

As an example, for basin and petroleum systems modeling, an optimization procedure may be applied to determine layer thicknesses of sediments at their respective times of deposition. Such a procedure can include reconstruction of depositional thicknesses of multiple individual sedimentary layers by backstripping a given present day multilayer geometry. As an example, reconstruction of depositional thickness can include decompacting a layer from a given present day thickness to a depositional thickness, for example, based on input of estimates for present day porosity and hydrostatic pore-pressure for that layer, where such estimates have some amount of error, uncertainty, etc. Based on decompaction of multiple layers to their respective historical times, a forward simulation in time may be performed, for example, to arrive at a calculated present day geometry for the multiple layers (e.g., as compacted over time) along with calculated present day porosities for the multiple layers.

A single backstripping and forward simulation cycle may provide calculated porosity values that are improved when compared to the estimated porosity values that were used for the backstripping. In the invention, to further improve porosity values, the calculated porosity values (e.g., predicted porosity values) are provided as inputs to backstripping of a subsequent backstripping and forward simulation cycle. In the invention, to yet further improve porosity values, one or more additional cycles are performed. Where multiple backstripping and forward simulation cycles are performed, it is referred to as an "optimization" procedure. Such an optimization procedure may include a number of cycles, for example, to arrive at a calculated (e.g., predicted) present day geometry of a sedimentary basin that appears sufficiently close to an actual present day geometry of the sedimentary basin. Over multiple cycles, results from such an optimization procedure tend to converge.

In the invention, a sedimentary basin is spatially modeled via a finite element grid for application of the FEM. Depending on the physical size of the sedimentary basin and resolution of the finite element grid, the number of unknowns may be of the order of millions. As an example, solution time or resource requirements may scale nonlinearly (e.g., exponentially) with respect to number of finite elements (e.g., number of unknowns). As an example, doubling the number of finite elements along one dimension can increase computing effort by an order of magnitude. Accordingly, some trade-offs may exist as to solution accuracy (e.g., more finite elements) and solution timing (e.g., for fixed computing resources) or solution requirements (e.g., ability to increase number of cores, memory, etc.).

As to backstripping and forward simulation cycles in a certain optimization procedure, the number of finite elements is fixed, for example, as determined by a given sedimentary basin model (e.g., built based on seismic and optionally other types of data). In such an optimization procedure, the time to perform each of the cycles is approximately constant. For example, if each cycle takes about 10 hours to perform then a three cycle optimization procedure may be expected to take about 30 hours to perform.

In the invention, to reduce total time of an optimization procedure, the method includes utilizing a hierarchy of successively refined finite element grids for cycles of the optimization procedure. In an embodiment, given a model with N finite elements, a first cycle of an optimization procedure may use N/2 finite elements. In such an example, a last cycle may increase the number of finite elements, for example, to N finite elements such that final results of the optimization procedure align with the given model (e.g., a one-to-one finite element correspondence).

In the invention, the optimization procedure includes using a coarse resolution grid and a fine resolution grid where use of the coarse resolution grid occurs prior to use of the fine resolution grid. The optimization procedure is sped up compared to an optimization procedure that does not include using a coarse grid (e.g., where cycles use a fine resolution grid).

As an example, an optimization procedure can include reducing resolution of a finite element grid used for solving pore-pressure differential equations in one or more cycles prior to a final cycle. In such an example, a final cycle may use a finite element grid without reduced resolution, for example, to provide the most precise pore-pressure result at the end of the optimization procedure. As an example, an optimization procedure may include increasing grid resolution in each successive cycle, for example, to end with a desired resolution at the final cycle.

As an example, where physical properties present in a basin model show a low variation within a layer, an optimization procedure may commence with a coarse lateral grid point distribution and decrease grid point distances for successive cycles. Such an approach can reduce execution time for pore-pressure and compaction calculations; noting that quality may be affected to varying degree in non-final cycles (e.g., compared to a final cycle performed at a finer grid resolution). As an example, time gained may allow for various options. For example, given an amount of time saved via use of a coarse grid (e.g., during one or more non-final cycles), time may be available for one or more additional optimization procedure cycles, which may improve the quality of final results.

Basin and petroleum systems modeling may assess generation, migration, and accumulation of hydrocarbons. Quantities such as pore pressure, geomechanical stresses and strains, temperature, and fluid potentials can assist understanding of a sedimentary basin and provide for an estimation of hydrocarbon generation, migration, and accumulation. These quantities may be described via formulations of equations that include partial differential equations (PDEs). A spatial distribution and evolution through geological time of such processes may be a goal of basin modeling.

As analytical solutions might not exist for PDEs, numerical simulation may be employed using a computing device, a computing system, etc. Various numerical techniques may include discretization of a space to form a model. For example, a finite element model may include many finite elements (e.g., a few million elements) where each element has an associated set of properties, for example, lithology (e.g., type of the material), porosity, temperatures, pore pressure, etc. Alignment of a grid for finite elements with geological features such as layer horizons and faults may help to provide an accurate and efficient simulation of physical phenomena.

In an example, a method can include creating or providing a grid that is suitably aligned with one or more geological features while allowing for an efficient implementation and simulation on a computing device or computing system. Such a method can include providing a basic grid construction so that it is suitably aligned with various features of a model (e.g., global features, layer horizons for a basin, etc.), optionally followed by improving the description of local features (e.g., faults, etc.) by locally altering the grid by splitting an existing finite element into two (or possibly more) smaller finite elements and by shifting the position of one or more nodes of the smaller finite elements. In such a manner, an improved grid may be generated (e.g., that defines various finite elements).

The FEM can include mapping (e.g., spatial transformations), for example, where a finite element is mapped from a physical space to a unit space to facilitate integration. Such an approach allows for various finite element shapes in the physical space (or physical domain being modeled). In contrast, other techniques for spatial modeling such as finite difference or finite volume methods can exhibit numerical problems when considering deformed grids. In certain cases, these numerical problems may be severe. While mapping or transforms may be applied to these other techniques, they might not be inherent to those other techniques and may act to increase computational demands.

For a finite element, material properties (e.g., rock or other material) may be uniformly defined. A grid for finite elements (e.g., to define node positions for finite elements) may be aligned to geological features to describe geological volumes. A model may represent geological volumes in one or more dimensions in space (e.g., 1D, 2D, or 3D). For example, for a 2D model, two-dimensional finite elements may represent volumes that interact with neighboring two-dimensional finite elements (e.g., for rectangular elements, an interior element may have four neighbors with shared boundaries and four additional neighbors with a shared node). For a 3D model, an interior cuboid element may have six neighbors with shared surfaces and, for example, up to an additional twenty four neighbors with a shared node (e.g., eight nodes with three additional neighbors per node, noting that the number can differ for collapsed surfaces, etc.). In the invention, the method operates on a 2D spatial finite element model. In an embodiment, the method can operate on a 3D spatial finite element model. A temporal dimension may make such models 3D and 4D overall.

Various issues exist for modeling and simulation of hydrocarbon generation and migration. In particular, model accuracy with respect to physical geometry and porosities of a geologic formation can impact accuracy (e.g., hydrocarbon migration pathways may follow small scale structures with high porosities). Where mismatches exist between physical geometry and model geometry or where inaccuracies exist in porosity values, errors may be propagated in simulation results for hydrocarbon generation and migration. Such errors may impact exploration and appraisal of a basin and resources therein, for example, as to pressure prediction and well placement.

As mentioned, an optimization procedure may be applied to a model of a basin, which may be, for example, a pre-existing model for which some improvement is desired. Such a model may be based on various types of data. For example, seismic data may be acquired and analyzed to understand better geometry, layers, etc., of a basin. As an example, a process referred to as seismic-to-simulation may be performed where data such as seismic data is interpreted and processed to arrive at a simulation model. In turn, such a simulation model may be subject to an optimization procedure, for example, prior to petroleum systems modeling. As an example, consider use of the PETREL@ seismic-to-simulation framework (Schlumberger Limited, Houston, Texas) to arrive at a simulation model followed by use of the PETROMOD® framework to perform petroleum systems modeling (e.g., using the FEM). In such an example, an optimization procedure may be performed on a given model (e.g., built using the PETREL@ framework) for purposes of petroleum systems modeling (e.g., using the PETROMOD® framework).

As an example, model building, performance of an optimization procedure and simulation of petroleum systems using a model or models may occur using, in part, an interconnecting framework environment that acts to coordinate tasks, share data, etc. As an example, a system may include such an interconnecting framework to perform tasks, workflows, etc., that may allow one to understand better a geologic environment (e.g., its past, present or future characteristics or behavior). Such a system may be capable of accessing data, performing simulations and controlling one or more processes, etc., for example, to assist in production of a resource (e.g., drilling, producing, injecting, etc.).

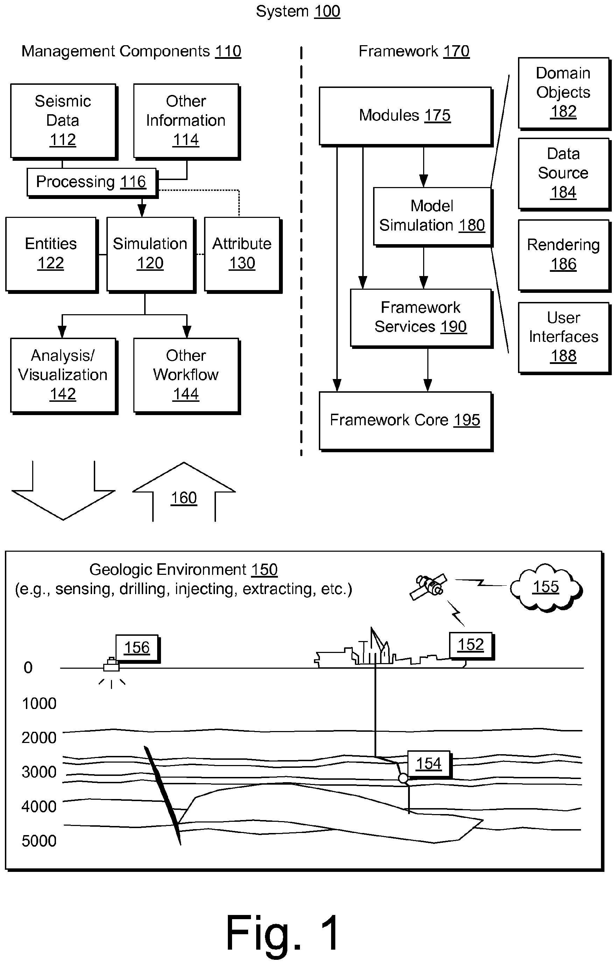

Fig. 1 shows an example of a system 100 that includes various management components 110 to manage various aspects of a geologic environment 150. For example, the management components 110 may allow for direct or indirect management of sensing, drilling, injecting, extracting, etc., with respect to the geologic environment 150. In turn, further information about the geologic environment 150 may become available as feedback 160 (e.g., optionally as input to one or more of the management components 110).

In the example of Fig. 1, the management components 110 include a seismic data component 112, an additional information component 114 (e.g., well/logging data), a processing component 116, a simulation component 120, an attribute component 130, an analysis/visualization component 142 and a workflow component 144. In operation, seismic data and other information provided per the components 112 and 114 may be input to the simulation component 120.

In an example, the simulation component 120 may rely on entities 122. Entities 122 may include earth entities or geological objects such as wells, surfaces, reservoirs, etc. In the system 100, the entities 122 can include virtual representations of actual physical entities that are reconstructed for purposes of simulation. The entities 122 may include entities based on data acquired via sensing, observation, etc. (e.g., the seismic data 112 and other information 114).

In an example, the simulation component 120 may rely on a software framework such as an object-based framework. In such a framework, entities may include entities based on pre-defined classes to facilitate modeling and simulation. A commercially available example of an object-based framework is the MICROSOFT® .NET™ framework (Redmond, Washington), which provides a set of extensible object classes. In the .NET™ framework, an object class encapsulates a module of reusable code and associated data structures. Object classes can be used to instantiate object instances for use in by a program, script, etc. For example, borehole classes may define objects for representing boreholes based on well data.

In the example of Fig. 1, the simulation component 120 may process information to conform to one or more attributes specified by the attribute component 130, which may include a library of attributes (e.g., seismic attributes, etc.). Such processing may occur prior to input to the simulation component 120. Alternatively, or in addition, the simulation component 120 may perform operations on input information based on one or more attributes specified by the attribute component 130. In an example, the simulation component 120 may construct one or more models of the geologic environment 150, which may be relied on to simulate behavior of the geologic environment 150 (e.g., responsive to one or more acts, whether natural or artificial). In the example of Fig. 1, the analysis/visualization component 142 may allow for interaction with a model or model-based results. Additionally, or alternatively, output from the simulation component 120 may be input to one or more other workflows, as indicated by a workflow component 144.

In an example, the management components 110 may include features of a commercially available framework such as the PETREL® seismic-to-simulation framework. The PETREL® framework provides components that allow for optimization of exploration and development operations. The PETREL® framework includes seismic to simulation code components that can be executed to output information for use in increasing reservoir performance, for example, by improving asset team productivity. Through use of such a framework, various professionals (e.g., geophysicists, geologists, and reservoir engineers) can develop collaborative workflows and integrate operations to streamline processes. Such a framework may be considered an application and may be considered a data-driven application (e.g., where data is input for purposes of simulating a geologic environment).

In an example, the management components 110 may include or interact with features of a commercially available simulation framework such as the PETROMOD® petroleum systems modeling framework. The PETROMOD® framework includes 1D, 2D, and 3D packages as well as add-ons and PETREL® framework plug-ins. As an example, a plug-in may allow PETREL® to exchange data with the PETROMOD® framework and vice-versa.

The PETROMOD® framework provides for petroleum systems modeling via input of various data such as seismic data, well data and other geological data, for example, to model evolution of a sedimentary basin. The PETROMOD® framework may predict if, and how, a reservoir has been charged with hydrocarbons, including the source and timing of hydrocarbon generation, migration routes, quantities, pore pressure and hydrocarbon type in the subsurface or at surface conditions. In combination with a framework such as the PETREL® framework, workflows may be constructed to provide basin-to-prospect scale exploration solutions. Data exchange between frameworks can facilitate construction of models, analysis of data (e.g., PETROMODO framework data analyzed using PETREL® framework capabilities), and coupling of workflows.

In an example, various aspects of the management components 110 (e.g., or other components) may include add-ons or plug-ins that operate according to specifications of a framework environment. For example, a commercially available framework environment such as the OCEAN® framework environment allows for seamless integration of add-ons (or plug-ins) into a PETREL® framework workflow. The OCEAN® framework environment leverages .NET® tools (Microsoft Corporation, Redmond, Washington) and offers stable, user-friendly interfaces for efficient development. In an example, various components may be implemented as add-ons (or plug-ins) that conform to and operate according to specifications of a framework environment (e.g., according to application programming interface (API) specifications, etc.).

Fig. 1 also shows an example of a framework 170 that includes a model simulation layer 180 along with a framework services layer 190, a framework core layer 195 and a modules layer 175. The framework 170 may include the commercially available OCEAN® framework environment where the model simulation layer 180 includes the commercially available PETREL@ seismic-to-simulation framework that hosts OCEAN® framework environment applications. In an example, the PETREL® software may be considered a data-driven application. As an example, a framework (e.g., consider the PETREL@ framework) may include features for model building and visualization.

The model simulation layer 180 may provide domain objects 182, act as a data source 184, provide for rendering 186 and provide for various user interfaces 188. Rendering 186 may provide a graphical environment in which applications can display their data while the user interfaces 188 may provide a common look and feel for application user interface components.

In the example of Fig. 1, the domain objects 182 can include entity objects, property objects and optionally other objects. Entity objects may be used to geometrically represent wells, surfaces, reservoirs, etc., while property objects may be used to provide property values as well as data versions and display parameters. For example, an entity object may represent a well where a property object provides log information as well as version information and display information (e.g., to display the well as part of a model).

In the example of Fig. 1, data may be stored in one or more data sources (or data stores, generally physical data storage devices), which may be at the same or different physical sites and accessible via one or more networks. The model simulation layer 180 may be configured to model projects. As such, a particular project may be stored where stored project information may include inputs, models, results and cases. Thus, upon completion of a modeling session, a user may store a project. At a later time, the project may be accessed and restored using the model simulation layer 180, which can recreate instances of the relevant domain objects.

In the example of Fig. 1, the geologic environment 150 may be outfitted with any of a variety of sensors, detectors, actuators, etc. For example, equipment 152 may include communication circuitry to receive and to transmit information with respect to one or more networks 155. Such information may include information associated with downhole equipment 154, which may be equipment to acquire information, to assist with resource recovery, etc. Other equipment 156 may be located remote from a well site and include sensing, detecting, emitting or other circuitry. Such equipment may include storage and communication circuitry to store and to communicate data, instructions, etc.

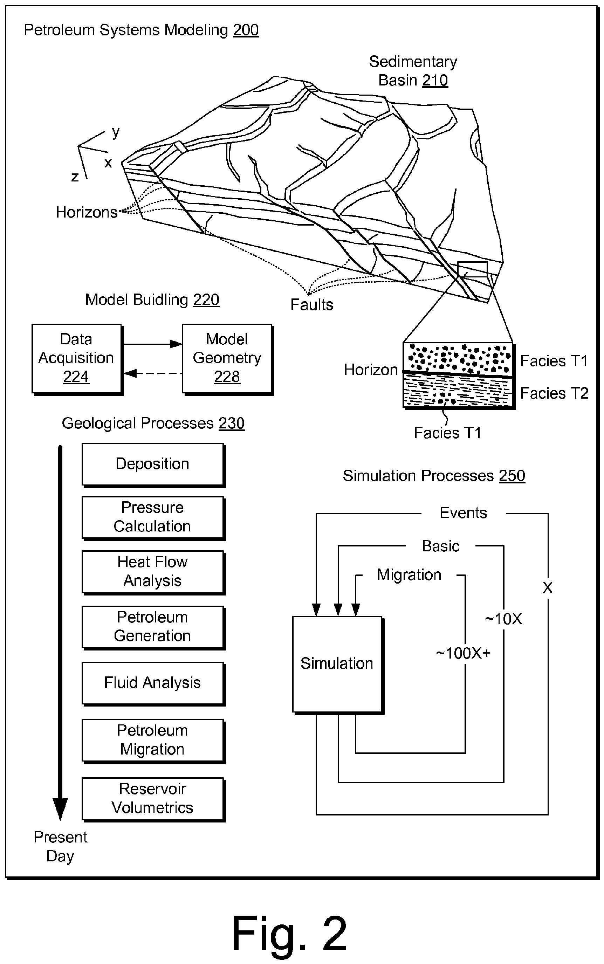

Fig. 2 shows various aspects of an example of petroleum systems modeling 200, including a sedimentary basin 210, model building 220, geological processes 230 and simulation processes 250. In general, petroleum systems modeling may be applied to various types of subsurface environments, including environments such as the underwater geologic environment 150 of Fig. 1.

In Fig. 2, the sedimentary basin 210 includes horizons, faults and facies formed over some period of geologic time. These features are distributed in two or three dimensions in space, for example, with respect to a Cartesian coordinate system (e.g., x, y and z) or other coordinate system (e.g., cylindrical, spherical, etc.). The model building 220 includes a data acquisition block 224 and a model geometry block 228. Some data may be involved in building an initial model and, thereafter, the model may optionally be updated in response to model output, changes in time, physical phenomena, additional data, etc. As mentioned, a model may be subject to one or more cycles as part of an optimization procedure. As an example, data for modeling may include one or more of the following: depth or thickness maps and fault geometries and timing from seismic, remote-sensing, electromagnetic, gravity, outcrop and well log data. Furthermore, data may include depth and thickness maps stemming from facies variations (e.g., due to seismic unconformities) assumed to following geological events ("iso" times) and data may include lateral facies variations (e.g., due to lateral variation in sedimentation characteristics).

To proceed to modeling of the geological processes 230, data are provided, for example, data such as geochemical data (e.g., temperature, kerogen type, organic richness, etc.), timing data (e.g., from paleontology, radiometric dating, magnetic reversals, rock and fluid properties, etc.) and boundary condition data (e.g., heat-flow history, surface temperature, paleowater depth, etc.).

The geological processes 230 may be part of a forward modeling process that performs calculations to simulate phenomena such as sediment burial, pressure and temperature changes, kerogen maturation and hydrocarbon expulsion, migration and accumulation. For example, a deposition block may account for sedimentation, erosion, salt doming, geologic event assignment; a pressure calculation block may account for pressure calculation and compaction; a heat flow analysis block may account for kinetics of thermal calibration parameters and calculate temperatures; a petroleum generation block may account for generation, adsorption and expulsion; a fluid analysis block may account for phase and compositions of fluid(s); a petroleum migration block may account for Darcy flow, diffusion, invasion percolation, and flowpath analysis; and a reservoir volumetrics block may account for column height of an accumulation, capillary entry pressure of a seal, leakage, break through, secondary cracking, and biodegradation.

With respect to simulation processes 250, one or more loops may be implemented, for example, according to time scales for various phenomena. In the example of Fig. 2, three loops are shown: Events, Basic and Migration. An events loop may characterize a geological period in which one layer has been uniformly deposited or eroded or when a geological hiatus occurred. A total number of events (e.g., iterations of the loop) may be based on the order of the number of geological layers (e.g., approximately between 20 and 50). With respect to a basic loop, events may be subdivided into basic time steps, for example, with a solution for pressure or compaction and heat equations. The length of a basic time step can depend on deposition or erosion amounts and on a total duration of an event. For example, a total number of basic time steps may be between approximately 200 and 500. As to a migration loop, these may stem from further division of basic loop time steps. For example, migration steps may provide for a Darcy flow analysis where transported fluid amount for an element of a model may be restricted to a pore area or volume of that element (e.g., depending on dimensionality of the model element). A total number of steps for migration may be approximately 1,000 up to 50,000 or more, which may depend on flow activity, rock permeability, selected migration modeling technique, etc. In the example of Fig. 2, the loops are shown with some examples of scaling from X for the events loop, approximately 10X for the basic loop and approximately 100X or more for the migration loop.

As to transport processes (e.g., heat flow, pore pressure and compaction, Darcy flow migration processes and diffusion), a model may aim to account for a flow variable acting from a first location onto another location. For example, given temperature as a state variable and heat flow as a corresponding flow variable, a difference in temperature with respect to space (e.g., a temperature gradient) causes heat flow, which generally acts to decrease a temperature difference (e.g., drive toward an equilibrium temperature). As mentioned, boundary conditions may be provided to formulate a boundary value problem guided, for example, by an energy or mass balance to provide state and flow variable values with respect to time.

A formulated boundary value problem may be solved for state and flow variable values with respect to time using one or more numerical techniques. For example, the finite element method (FEM) may include defining finite elements that fill a geological space (e.g., in 1D, 2D or 3D) where time steps occur using a finite difference technique. In such an example, at each time step, a finite element model may be solved (e.g., in a linear or nonlinear manner) and, once solved, a finite difference technique may act to "perturb" or "estimate" state values for a forward time (e.g., which may be in the future or past) or reverse time (backward time, e.g., which may be in the future or past), where these values are used as an initial estimate to solve the finite element model at the iterated time (e.g., finite element method for spatial modeling and finite difference for temporal modeling).

In an example, neighboring finite elements may be linked at a shared boundary (e.g., a point, a line or a surface) where the boundary conditions for two or more neighboring finite elements may be matched (e.g., energy-wise, material-wise, etc.). As an example, consider a mass of fluid exiting one finite element and entering a neighboring finite element (e.g., adjacent finite element). Where the porosity of the two finite elements differs, fluid velocity may differ for each finite element while mass and momentum are conserved across their shared boundary. Similar types of examples exist for other phenomena such as temperature and heat energy.

With respect to solving a finite element model using the finite element method (FEM), inversion of a matrix can provide for a solution vector (e.g., for state variables of various finite elements). As an example, a finite element model may include many finite elements (e.g., approximately thousands) with many unknowns (e.g., approximately thousands). Larger finite element models can include, for example, more than approximately a million finite elements with over approximately a million unknowns. Solution time or resources requirements may depend on the number of unknowns, number of linked equations, linearity or nonlinearity of a formulation of equations, property dependence on one or more state variables, etc. Solution time or resource requirements may be determined on the basis of a relationship between matrix inversion and number of unknowns as well as knowledge of other factors such as matrix diagonality. In general, solution time or resource requirements may scale nonlinearly (e.g., exponentially) with respect to number of finite elements (e.g., number of unknowns). As an example, doubling the number of finite elements along one dimension can increase computing effort by an order of magnitude. Accordingly, some trade-offs may exist as to solution accuracy (e.g., more finite elements) and solution timing (e.g., for fixed computing resources) or solution requirements (e.g., ability to increase number of cores, memory, etc.).

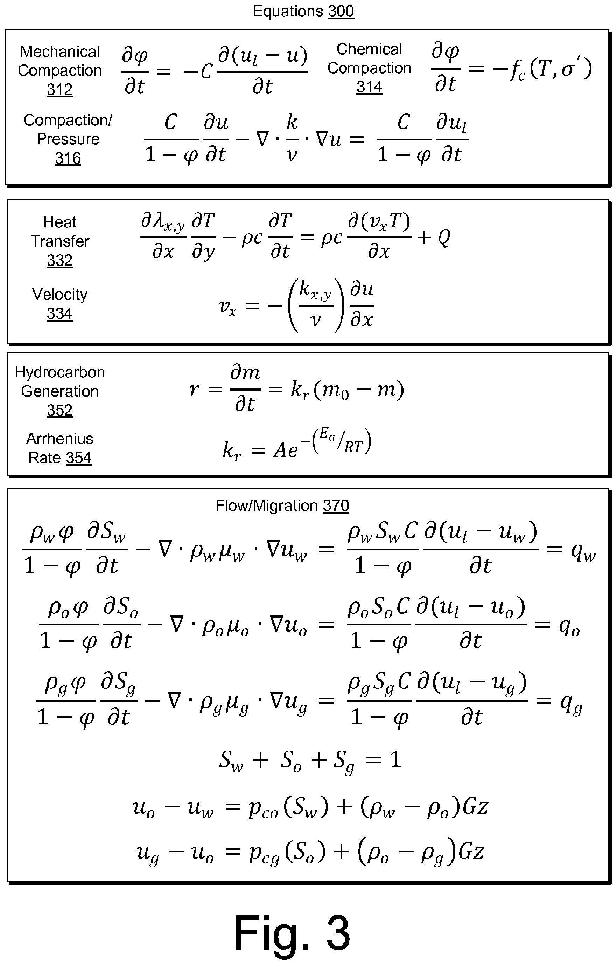

Fig. 3 shows examples of equations 300 that may be used for modeling petroleum systems. Equations 312, 314 and 316 represent compaction and pressure phenomena, equations 332 and 334 represent heat transfer, equations 352 and 354 represent hydrocarbon generation and equations 370 represent flow/migration of multiple components and multiple phases (e.g., water, oil and gas). As indicated, petroleum systems modeling can include variables (e.g., material properties) such as porosity ($\varphi$) and compressibility of material (e.g., rock) ($C$), hydraulic potential of effective stress ($u$) (e.g., consider stress tensor $\sigma$, external load $\tau$, and fluid pressure, ($p$), thermal conductivity tensor ($\lambda_{i,j}$), density ($p$), heat capacity ($c$), fluid velocity tensor ($v_i$), permeability tensor ($k_{i,j}$), viscosity ($v$), mobility ($\mu$), Arrhenius rate constants ($k_r$), temperature ($T$), saturation ($S$), capillary pressure ($p_c$), and volumetric flow ($q$). As indicated in Fig. 3, chemical compaction induced porosity loss as a function of temperature and effective stress may be included in an analysis (e.g., per the equation 314). Other variables may include one or more diffusion coefficients ($D_c$) where a diffusion flux occurs in response to a concentration gradient of a component or components ($c_i$). Nonlinearities may be inherent in one or more equations or stem from dependencies (e.g., consider Arrhenius rate constant with respect to temperature, convection, etc.). Accounting for nonlinearities may increase solution effort, however, they may also increase resource requirements.

As indicated, one or more variables may be anisotropic. For example, a tensor variable may differ depending on direction. Orientation of material with respect to gravity may also be a factor, for example, a material type (e.g., facies) may be compactable in a particular direction when acted upon by a load due to gravity. In such an example, permeability of the material may likewise be impacted due to its orientation with respect to gravity. As shown in the flow/migration equations 370, gravity ($G$) may be included in an equation for pressure or buoyancy (e.g., water flow may depend on a difference between a pressure and a head pressure determined on the basis of a water density ($\rho_w$), gravity ($G$) and depth ($z$)).

The equations 300 of Fig. 3 are provided as examples to explain some variables and partial differentials that may be used to represent various phenomena. While the equations may reference some dimensions (e.g., x, y, z), equations may be formulated in one, two or three dimensions in space, where time may be viewed as an additional dimension (e.g., 3D in space and 1D in time to provide a 4D formulation). The equations 332, 334, 352 and 354 also illustrate how transport of heat energy can impact hydrocarbon generation, for example, by increasing or decreasing temperature and thereby altering the Arrhenius rate constant for rate of formation of a hydrocarbon with respect to time. The heat transfer equation 332 also includes a source term ($Q$), which may account for radioactive processes or other heat source/sink processes.

Given equations such as those of Fig. 3, petroleum expulsion and migration may be modeled and simulated, for example, with respect to a period of time. Petroleum migration from a source material (e.g., primary migration or expulsion) may include use of a saturation model where migration-saturation values control expulsion. Determinations as to secondary migration of petroleum (e.g., oil or gas), may include using hydrodynamic potential of fluid and accounting for driving forces that promote fluid flow. Such forces can include buoyancy gradient, pore pressure gradient, and capillary pressure gradient (see, e.g., the equations 370).

The finite element method (FEM) is suitable for modeling phenomena that can be formulated via partial differential equations (PDEs) as well as other types of equations. The aforementioned PETROMOD® framework includes features for finite element models to be solved using the FEM, optionally with time discretization achieved via a finite difference approach.

In an example finite element model, each finite element can include properties to match the finite element to some physical space (e.g., line, surface, or volume, noting that dimensional reductions may be applied via symmetry or other bases). As an example, consider a finite element that include facies-related properties for a particular location as well as information (e.g., coordinates, index, indexes, etc.) to define its location. Given a location and facies related properties, for example, compaction and pressure determinations may be made for the finite element using the FEM.

In an example geologic layer disposed between or defined by an upper horizon and a lower horizon, adjacent finite elements may differ, for example, based on their respective facies. Where a fault exists in a layer, the fault may mark a discontinuity between facies (e.g., rock facies, organic facies, etc.). For example, on one side of the fault, a finite element may be assigned facies set A while on the other side of the fault, an adjacent, neighboring finite element may be assigned facies set B, hence, a discontinuity exists in properties of the neighboring finite elements (e.g., which may affect flow, etc., at or across a fault).

In general, a relationship exists between size of a finite element and the phenomenon or phenomena being modeled. Various scales may exist within a geologic environment, for example, a molecular scale may be on the order of approximately $10^{-9}$ to $10^{-8}$ meters, a pore scale may be on the order of approximately $10^{-6}$ to $10^{-3}$ meters, bulk continuum may be on the order of approximately $10^{-3}$ to $10^{-2}$ meters, and a basin scale on the order of approximately $10^3$ to $10^5$ meters. Given such scales, a finite element model may include finite elements having sizes on the order of approximately 1 to $10^2$ meters (e.g., smaller than a basin scale and larger than a pore scale). In a finite element model, a continuous crossover within a finite element can, for example, dictate a comparison between a bulk continuum scale and a basin scale rather than the finite element size and the basin scale as for some other types of numerical discretization techniques. Implicitly, finite elements can provide for higher resolution than some other types of numerical discretization techniques given the same "discretization" dimension (e.g., comparing a finite element to a "cell" of another technique). A finite element model may include multiple finite element sizes, optionally where a size corresponds to a phenomenon or phenomena to be modeled. As an example, heat flow may be modeled using finite elements having sizes less than approximately 100 meters whereas finite elements to model migration of hydrocarbons may be smaller.

As mentioned, the number of finite elements can determine, in part, a number of unknowns and solution time or resource requirements. A finite element model of a basin may span, for example, approximately hundreds of kilometers or a few kilometers. Model resolution may aim to approximate geological structures of interest while allowing for suitable simulation run times on available computing resources. A finite element model may include over a million finite elements, for example, with several thousand finite elements along a horizontal dimension. As an example consider a two-dimensional finite element model that may include about 3,000 finite elements along a lateral dimension (e.g., horizontal) and about 300 finite elements along a depth dimension (e.g., vertical).

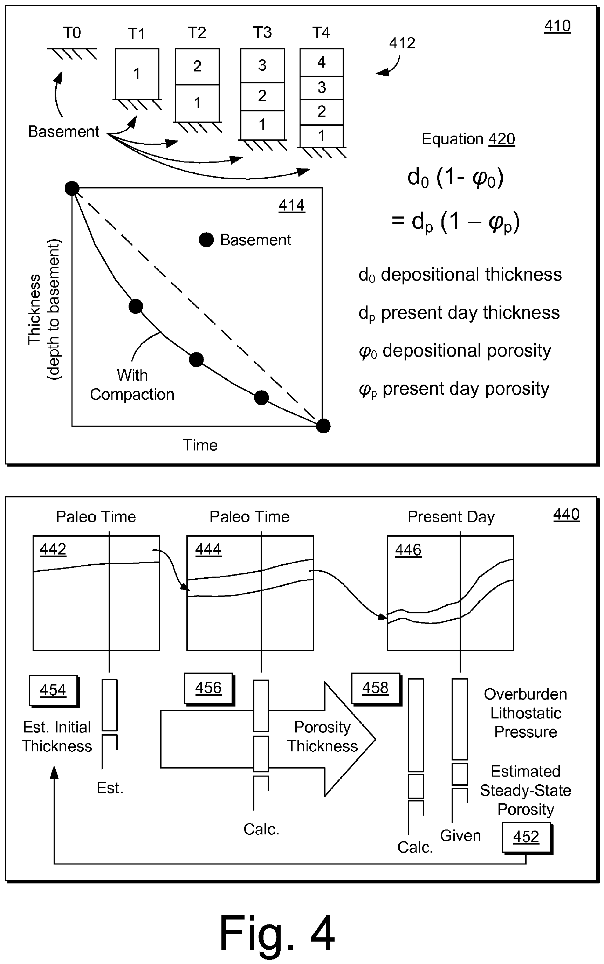

Fig. 4 shows an example of processes 410 and 440 that relate to backstripping and forward simulation of a multilayer sedimentary basin. Such processes may optionally implement the FEM, for example, using a finite element grid. As to backstripping, it may be referred to at times as "event stepping," for example, where paleo-geometries are reconstructed from a present day geometry due to given "geological events". As an example, a first cycle of backstripping and forward simulation may use an estimation of present day porosities (e.g., used as steady state values for hydrostatic pressure conditions) for decompaction where forward simulation yields calculated present day geometry based on pore pressure controlled compaction, for example, where the calculated present day geometry may differ from the present day geometry. In such an example, a second cycle of backstripping and forward simulation can now use calculated present day porosity for decompaction (e.g., rather than the estimated steady state values).

As to the process 410, as shown in a graphic 412 and a plot 414 of thickness (e.g., depth to a basement) with respect to time, at an initial time, T0, a basement exists which defines a base level. As time progresses, the depth of the basement (e.g., the base level) will increase (e.g., for times T1, T2, T3 and T4).

As an example, the process 410 may be part of a backstripping and forward simulation process. For example, multilayer backstripping can include observing a present day fully lithified, stratigraphic sequence that includes four compacted layers 1, 2, 3 and 4 (e.g., or "units"). At a deposition time for layer 1, layer 1 is decompacted to its original thickness and density. At a restoration time T1 for layer 1 and the basement, the basement depth in the absence of layer 1 is isostatically restored to recover its subsidence depth at the restoration time T1 (see, e.g., the basement depth at time T1 in the plot 414). At a deposition time for layer 2, layer 2 is then decompacted to its original thickness and layer 1 is compacted according to its new depth. At a restoration time T2 for layers 1 and 2 and the basement, the decompacted layer 2 and the partially compacted layer 1 are backstripped to recover the basement subsidence depth at the restoration time T2 (see, e.g., the basement depth at time T2 in the plot 414). The process continues for layers 3 and 4 such that the basement depth progresses deeper with respect to time, for example, as shown in the plot 414.

In the example of Fig. 4, the plot 414 the depth of the basement progresses in a nonlinear manner with respect to time, for example, determined in part by use of the compaction equation 420. In such an example, each of the layers is assigned a deposition thickness and a depositional porosity at the time of deposition and, due to compaction, ultimately present day thicknesses and present day porosities result. In contrast, a straight diagonal line in the plot 414 corresponds to sediment accumulation with respect to time without compaction. Again, as shown in the plot 414, where compaction is taken into account for the process 410, the basement moves nonlinearly with respect to time in response to events that deposit sediment over the basement.

As to the process 440 of Fig. 4, plots 442, 444 and 446 show examples of sediment evolution with respect to time for paleo times (e.g., historical geologic times) and for present day. As an example, the process 440 of Fig. 4 may be described in a simplified manner with respect to blocks 452, 454, 456 and 458 as being a backstripping with decompaction and forward simulation cycle that provides calculated porosities, which, in turn, may be used in a subsequent cycle.

In the example of Fig. 4, the process 440 includes, for present day, an estimation block 452 that may provide an estimated steady-state porosity for a layer in a given sequence of layers of sediment (e.g., for a first cycle). Given the estimated porosities, another estimation block 454 estimates an initial thickness for that layer where that initial thickness may be deemed to correspond to a paleo time, for example, a time at which the layer was deposited. In a forward simulation block 456, porosities and thickness are calculated and, to account for additional layers deposited in paleo time, a results block 458 provides for calculated porosities and thicknesses (e.g., geometry) for present day. In turn, the given and the calculated information may be compared and a decision made to repeat the cycle, however, rather than using the estimated steady-state porosity (e.g., porosities), the results of the results block 458 may be provided to enhance the initial thickness estimates per the estimates block 454 in a subsequent cycle. Additional cycles may be performed, for example, until results given by the results block 458 converge.

Referring again to the equation 420, it may be used to decompact layers, for example, assuming conservation of solid matrix volume. Present day porosities may not be known a *priori* as they can depend on pore pressure development. Thus, when performing a first backstripping and forward simulation cycle, estimated present day porosities may be used as the steady-state values for hydrostatic pressure conditions. As an example, forward simulation can calculate present day geometry based on pore pressure controlled compaction, which may yield results that differ from the given present day geometry. As mentioned, in a subsequent cycle, the difference between calculated present day geometry and the given present day geometry will likely diminish as calculated present day porosities are provided based on decompaction, in contrast to the first cycle steady-state estimates.

As an example, erosion may also be modeled, for example, where definitions are provided for eroded thicknesses and erosion ages. As an example, eroded thicknesses may be given with virtual horizons or thicknesses at time of deposition, at present day or other geologic events. As an example, multiple erosions of one layer and one erosion on multiple layers may be recognized with virtual horizons. Interpretation of eroded thicknesses may, for example, be performed using a backstripped and decompacted paleo-geometry. In such an example, porosity at the erosion age may be considered for decompaction of overconsolidated rocks.

As an example, horizontal movements of layers like salt may be described with addition of thickness maps, for example, during doming. Such changes may be realized by layer stretching and thinning. As an example, one or more salt maps may be provided for various geologic events (e.g., based on kinematic models) that may be taken into consideration during a cycle. Where salt domes, salt pillows, etc., are modeled, high overburden may result in reverse structures. Various techniques may be applied, for example, to handle salt intrusions, for example, into one or more overburden layers.

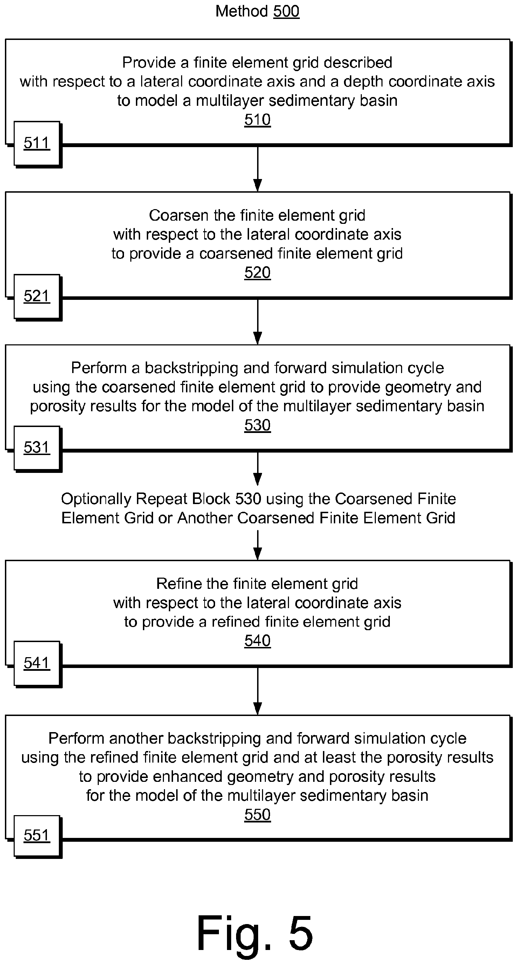

Fig. 5 shows the method 500 according to the invention, that includes performing multiple backstripping and forward simulation cycles. As shown, the method 500 includes a provision block 510 for providing a finite element grid described with respect to a lateral coordinate axis and a depth coordinate axis to model a multilayer sedimentary basin; a coarsen block 520 for coarsening the finite element grid with respect to the lateral coordinate axis to provide a coarsened finite element grid; a performance block 530 for performing a backstripping and forward simulation cycle using the coarsened finite element grid to provide geometry and porosity results for the model of the multilayer sedimentary basin; a refinement block 540 for refining the finite element grid with respect to the lateral coordinate axis to provide a refined finite element grid; and a performance block 550 for performing another backstripping and forward simulation cycle using the refined finite element grid and at least the porosity results to provide enhanced geometry and porosity results for the model of the multilayer sedimentary basin.

As shown in the example of Fig. 5, between the performance block 530 and the refinement block 540, the performance block 530 may optionally be repeated using the coarsened finite element grid or another coarsened finite element grid. Where the method 500 implements such an option, a backstripping and forward simulation cycle may be performed using at least the porosity results of a prior cycle to provide geometry and porosity results, which, in turn, may be used in the performance block 550.

As an example, the refinement block 540 may include interpolating results associated with the coarsened finite element grid to provide intermediate values for association with the refined finite element grid. In turn, the performance block 550 may perform its cycle based on the results of the performance block 530 as well as interpolated values derived from those results.

The method 500 is shown in Fig. 5 in association with various computer-readable storage media (CRM) blocks 511, 521, 531, 541, and 551. Such blocks generally include instructions suitable for execution by one or more processors (or cores) to instruct a computing device or system to perform one or more actions. While various blocks are shown, a single medium may be configured with instructions to allow for, at least in part, performance of various actions of the method 500.

As mentioned, where physical properties present in a basin model show a low variation within a layer, an optimization procedure may commence with a coarse lateral grid point distribution and decrease grid point distances for successive cycles such that execution time for pore-pressure and compaction calculations is reduced. In the example of Fig. 5, the method 500 may optionally include a preprocessing block that determines variation for one or more physical properties in one or more layers. In such an example, where variation is acceptably low, the method 500 may continue with coarsening as in the coarsen block 520. As an example, such coarsening may occur based at least in part on variation of one or more physical properties in one or more layers. For example, if a particular layer has more variation than other layers, the amount of coarsening may be determined based on that particular layer. In such an example, a coarsened horizontal grid resolution may be selected that maintains some amount of variation of one or more physical properties across finite elements (e.g., consider between adjacent finite elements) within that layer to be within a variation limit (or variation limits). As an example, consider normalized property values varying as approximately 0.6, 0.7, 0.9, and 0.8 for four adjacent lateral finite elements in a layer. Coarsening may be deemed acceptable in a manner that combines the two finite elements having values approximately 0.6 and approximately 0.7 (e.g., to an average value of approximately 0.65) and that combines the two finite elements having values approximately 0.9 and approximately 0.8 (e.g., to an average value of approximately 0.85), however, coarsening that would combine all of the finite elements may be deemed unacceptable as acting to average out an observed spatial difference for the particular property.

The invention relates to a computer-implemented method to iteratively model present day geometry of a multilayer sedimentary basin that includes providing a finite element model of a multilayer sedimentary basin represented on a finite element grid described with respect to a lateral coordinate axis and a depth coordinate axis, wherein the finite element grid comprises a lateral grid resolution and a depth grid resolution; coarsening the finite element grid with respect to the lateral coordinate axis to provide a coarsened finite element grid that comprises the depth grid resolution; performing a backstripping and forward simulation cycle using the coarsened finite element grid to provide present day geometry and porosity results for the model of the multilayer sedimentary basin; refining the coarsened finite element grid with respect to the lateral coordinate axis to provide a refined finite element grid that comprises the lateral grid resolution and the depth grid resolution; and performing backstripping and forward simulation cycle using the refined finite element grid and at least the porosity results to provide enhanced present day geometry and porosity results for the model of the multilayer sedimentary basin. In an embodiment, the backstripping and forward simulation cycle can include decompacting a layer of the model of the multilayer sedimentary basin. Such decompacting may include estimating a present day porosity for the layer and decompacting the layer to a depositional porosity for the layer. In this embodiment, the present day porosity for the layer may correspond to a present day thickness for the layer and the depositional porosity for the layer may correspond to a depositional thickness for the layer.

In an embodiment, the method can include assessing variation of porosity for a layer of a model of the multilayer sedimentary basin and performing coarsening of a finite element grid with respect to a lateral coordinate axis based at least in part on such assessing variation of porosity for the layer. As an example, such an approach may be applied to multiple layers and coarsening may be determined, for example, based on a layer that exhibits the most variation.

In the invention, the method includes repeatedly refining a finite element grid with respect to a lateral coordinate axis to provide a more refined finite element grid and performing a backstripping and forward simulation cycle using the more refined finite element grid and at least enhanced porosity results (e.g., from a prior cycle) to provide further enhanced geometry and porosity results for a model of a multilayer sedimentary basin as modeled by the finite element grid. As an example, a method may refine a finite element grid to arrive at a finite element grid that has a lateral grid resolution equivalent to a lateral grid resolution of a provided finite element grid (e.g., that was coarsened for performance of one or more backstripping and forward simulation cycles).

In an embodiment, the method can include providing a finite element grid that defines N finite elements and coarsening the finite element grid to provide a coarsened finite element grid that defines approximately N/2 finite elements. In this embodiment, the method may include refining the coarsened finite element grid to provide a refined finite element grid that defines N finite elements (e.g., to arrive at an original finite element grid resolution).

In an embodiment, the method can include providing a finite element grid that defines N finite elements and coarsening the finite element grid to provide a coarsened finite element grid that defines approximately N/4 finite elements. In this embodiment, the method may include refining the coarsened finite element grid to provide a refined finite element grid that defines N finite elements. While N/2 and N/4 are mentioned, coarsening may coarsen a finite element grid to provide a coarsened finite element grid that defines a different number of finite elements (e.g., approximately N/3, N/5, N/6, N/7, N/8, N9, etc.). As an example, a coarsening or refining process may include removing, grid nodes along spaced lateral coordinates, adding grid nodes along spaced lateral coordinates, replacing previously removed grid nodes along spaced lateral coordinates, etc. As an example, every other set of lateral grid nodes may be removed, added, or replaced; every third set of lateral grid nodes may be removed, added, or replaced; etc. As an example, a method may progressively coarsen, refine or coarsen and refine grid nodes.

In an embodiment, the method can include providing a three-dimensional finite element grid described with respect to a lateral coordinate axis, another lateral coordinate axis and the depth coordinate axis.

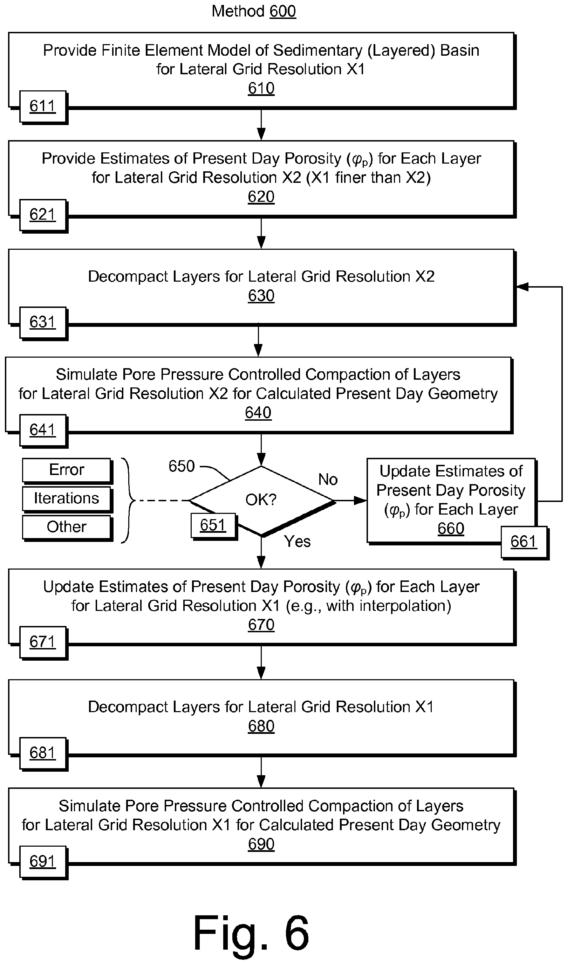

Fig. 6 shows an example of a method 600 that includes a provision block 610 for providing a finite element model of a sedimentary (layered) basin for a lateral grid resolution X1, a provision block 620 for providing estimates of present day porosity ($\varphi_p$) for each layer for a lateral grid resolution X2 (where X1 is finer than X2), a decompaction block 630 for decompacting layers of the lateral grid resolution X2, a simulation block 640 for simulating pore pressure controlled compaction of layers for the lateral grid resolution X2 for producing a calculated present day geometry, a decision block 650 for deciding whether the method 600 continues to block 630 and block 640 via an update block 660 for updating estimates of present day porosity ($\varphi_p$) for each layer, an update block 670 for updating estimates of present day porosity ($\varphi_p$) for each layer for the grid resolution X1 (e.g., optionally with interpolation), a decompaction block 680 for decompacting layers for the lateral grid resolution X1 (where X1 is finer than X2), and a simulation block 690 for simulating pore pressure controlled compaction of layers for the lateral grid resolution X1 for producing calculated present day geometry.

As to the decision block 650, as shown in the example of Fig. 6, it may decide on the basis of error, number of iterations (e.g., a maximum number of iterations) or another basis, which may including deciding based on a combination of factors. As mentioned, an optimization procedure may include multiple backstripping and forward simulation cycles where results from successive cycles tend to converge. As an example, an error may be defined with respect to two or more cycles and compared to a corresponding error limit. In such an example, where the error is less than (e.g., or less than or equal to) the error limit, the decision block 650 may decide to proceed to the update block 670, for example, to perform a final cycle at a finer lateral grid resolution, which may be the lateral grid resolution of the provided finite element model of the provision block 610.

The method 600 is shown in Fig. 6 in association with various computer-readable media (CRM) blocks 611, 621, 631, 641, 651, 661, 671, 681 and 691. Such blocks generally include instructions suitable for execution by one or more processors (or cores) to instruct a computing device or system to perform one or more actions. While various blocks are shown, a single medium may be configured with instructions to allow for, at least in part, performance of various actions of the method 600.

As an example not forming part of the invention, one or more computer-readable storage media can include computer-executable instructions to instruct a computing device to: access a finite element model of a multilayer sedimentary basin for a first lateral grid resolution; provide estimates of present day porosity for layers of the multilayer sedimentary basin for a second lateral grid resolution that is coarser than the first lateral grid resolution; decompact the layers of the multilayer sedimentary basin for the second lateral grid resolution; simulate pore pressure controlled compaction of the decompacted layers for the second lateral grid resolution to produce simulation results; and, based at least in part on the simulation results, decide whether to decompact and simulate using a third lateral grid resolution where the third lateral grid resolution is finer than the second lateral grid resolution. In such an example, the one or more computer-readable storage media may include computer-executable instructions to instruct a computing device to decompact the layers of the multilayer sedimentary basin for the third lateral grid resolution and simulate pore pressure controlled compaction of the decompacted layers for the third lateral grid resolution to produce simulation results. As an example, the third lateral grid resolution may be approximately the same as the first lateral grid resolution.

As mentioned, the evolution of pore-pressure and temperature in sedimentary basins over geological times may be described with partial differential equations. As an example, to solve these partial differential equations (PDEs), a finite element method (FEM) may be implemented for spatial discretization of a sedimentary basin along with, for example, a finite difference technique for paleo time stepping. In such an example, a finite element grid may follow layer geometry in a vertical direction (e.g., depth); whereas, grid points may be sampled in a horizontal direction (e.g., lateral direction), optionally with equal distance spacing. Where three spatial dimensions are taken into account, grid points may be sampled in two horizontal directions (e.g., two lateral directions), optionally with equal distance spacing in each direction or one distance spacing in one lateral direction and another distance spacing in the other lateral direction. As an example, lateral grid point spacing may be provided as a parameter for controlling lateral coarsening or lateral refining of a grid.

As to a workflow, consider a workflow for simulation of a basin model that includes an optimization procedure to determine thicknesses of sedimentary layers at their respective times of deposition. As an example, such a workflow may be accomplished as follows: After choosing a lateral grid resolution and constructing the finite element mesh, the thickness of the sediments at deposition time may be reconstructed by decompacting each layer from present day thickness to depositional thickness, with the assumption of the conservation of the solid matrix mass. During such a process an estimated initial value for the porosity of the sediment contained in each finite element (e.g., each 2D or 3D "element" or "cell") may be increased until the depositional porosity and layer thickness is reached.

In the course of a subsequent forward simulation, pore-pressure may be computed with an accuracy based on the finite element grid resolution. In such an example, the pore-pressure may be provided as input for compaction of sediments, which in turn yields a new estimation of the porosity. A result of a forward simulation may provide a prediction as to the present day geometry and porosity (e.g., calculated present day geometry and porosity).

As mentioned, a resulting present day geometry may not match an input geometry, however, the porosity may be provided as a starting value for an additional iteration of backstripping and forward simulation. By performing an additional backstripping and forward simulation cycle, a final result may more accurately reproduce present day geometry. As an example, an optimization procedure may include a few cycles, for example, to arrive at a geometry that is sufficiently close to that of a given model (e.g., original input data).

As described with respect to the method 500 and the method 600, an optimization procedure may optionally be accelerated by reducing resolution of a finite element grid (e.g., as used for solving the pore-pressure differential equations in early cycles). In such an example, the most precise pore-pressure result may be provided by a final optimization cycle. While the examples of Fig. 5 and Fig. 6 refer to a coarse grid and a finer grid, multiple coarse grids may be used, for example, to gradually increase the grid resolution in each cycle of an optimization procedure. As an example, a final cycle may provide a desired resolution that matches that of a model (e.g., a provided model as in the method 600 of Fig. 6).

As an example, for a model where physical properties show a low variation within layers, a method may include commencing with a coarse lateral grid point distribution and thereafter decreasing the grid point distances for one or more subsequent backstripping and forward simulation cycles. Such an approach may act to substantially reduce execution time for pore-pressure and compaction calculations, for example, while quality of the optimization procedure may be impacted for an initial cycle (e.g., or a couple of initial cycles). Time saved via such an approach may allow for more optimization runs (e.g., cycles) and thus may act overall to improve optimization quality of a final result.

As an example, a process of backstripping and forward simulation may be repeated several times where a calculated porosity of one backstripping and forward simulation cycle serves as input to a next cycle to improve predictions for present day geometry until a sufficiently accurate approximation of input data is achieved (e.g., input data for a given model such as in the method 600 of Fig. 6).

As an example, a method such as the method 500 or the method 600 may be implemented using instructions as part of a basin and petroleum systems modeling packages for exploration, appraisal, and pore pressure prediction in overpressured sediments.

As an example, overburden may be material (e.g., rock, etc.) overlying an area or point of interest in a subsurface or the weight of such material. As an example, the term "overpressure" may refer to subsurface pressure that may be high, for example, exceeding hydrostatic pressure at a given depth; noting that "underpressure" may refer to an area (e.g., zone or formation) where pore pressure may be less than "normal" or hydrostatic pressure (e.g., and may be associated with areas that have had hydrocarbon production). As an example, a compaction process can include sediment consolidation responsive to overburden pressure (e.g., as increasing during burial) that results in reduction of pore space (e.g., as grains are packed closer together) and loss of pore fluid. As an example, a method may involve data analysis, simulation, etc., that can provide for identification of one or more regions in a model of a geologic environment that include a pressure or pressures of interest (e.g., underpressures, overpressures, etc.). Such a method may include an optimization procedure and modeling of one or more geological events (e.g., deposition of material, erosion of material, shifting of material, etc.). As an example, such a method may include assessing phenomena such as hydrocarbon production (e.g., as part of petroleum systems modeling workflow, etc.).

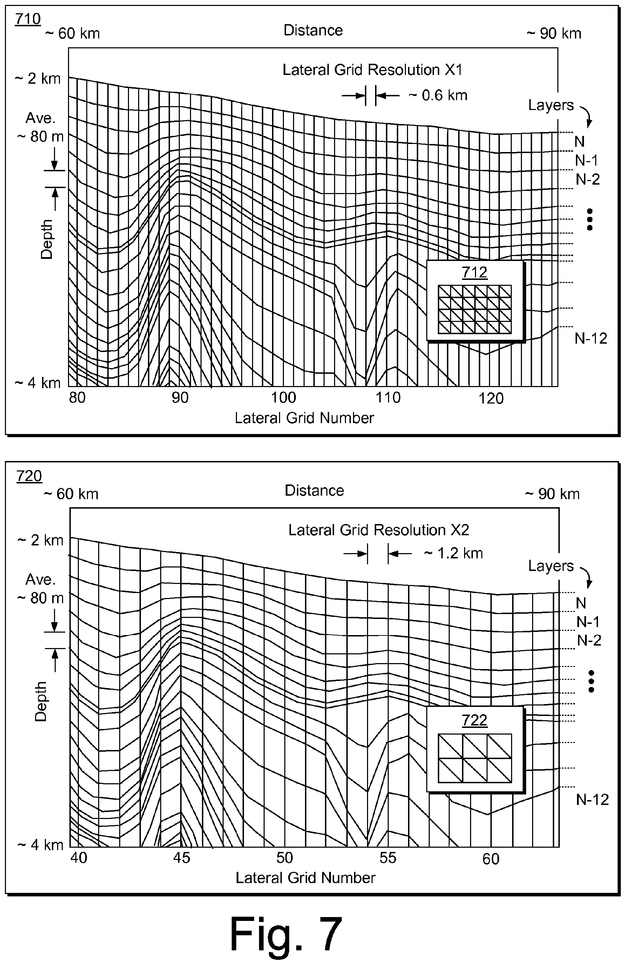

Fig. 7 shows an example of a portion of a fine resolution grid 710 and an example of a corresponding coarsened resolution grid 720, for example, coarsened by eliminating every other grid point in a lateral direction; noting that other types of coarsening may be used. In Fig. 7, approximate distances are given as examples to provide some context as to differences or relationships that may exist between lateral and depth distances, resolutions, etc. In the examples of Fig. 7, the depth grid resolution is maintained while coarsening occurs for the lateral grid resolution (e.g., from X1 to X2).

As shown in Fig. 7, the fine resolution grid 710 includes more than 12 layers over a depth of about 2 km and a lateral span of about 30 km. As shown, the layers may be horizons that define different types of sediment, geologic events, etc. These layers may be shifted vertically over the lateral span. As an example, the left hand side of the grid 710 includes about 25 layers over a depth of about 2 km, which yields an average depth grid spacing of about 80 m; noting that variations exist that correspond to thickness of individual layers.

Referring to the lateral grid spacing, lateral grid points may define vertical lines having corresponding lateral grid numbers, for example, ranging from about 80 to about 125. Where the lateral distance or span is about 30 km, the average lateral grid spacing is about 0.6 km (e.g., 600 m), which may be a constant spacing between lateral grid points. In a spatial domain, the grid 710 may define finite elements that include a lateral dimension of about 0.6 km and a depth dimension that corresponds to a layer thickness or, for example, a fraction of a layer thickness (e.g., where a layer is represented by multiple finite element in depth). As an example, a finite element may represent a lateral physical dimension of about 0.6 km and a depth physical dimension of about 80 m. As an example, the finite element method (FEM) may include transforming or mapping such finite elements to a unit square, for example, for purposes of integration, etc. Accordingly, the FEM may include quadrilateral finite elements with aspect ratios defined by a lateral dimension that exceeds a vertical dimension (e.g., about 600 m laterally by about 80 m vertically).

As to the grid 720, as mentioned, it includes fewer lateral grid points (e.g., lateral grid nodes). For example, rather than about 45 grid points, it includes about 23 grid points. In turn, the lateral grid resolution is reduced by coarsening to about 1.2 km between adjacent grid points. In such an example, the aspect ratio of the finite elements defined by the grid points also changes. Rather than being about 600 m laterally by about 80 m vertically, the aspect ratio is now about 1.2 km laterally by about 80 m vertically; noting that in Fig. 7, the scales differ and therefore do not visually portray the aspect ratio as if the scales were even (e.g., the finite elements appear at times as actually being taller than wider).

As an example, finite elements may be triangular, for example, an inset 712 shows triangular finite elements for a fine lateral grid resolution while an inset 722 shows triangular finite elements for a coarse lateral grid resolution. As an example, a grid may define quadrilateral and triangular finite elements.

As an example, a grid may define cubic, tetrahedral or other shaped finite elements suitable for filling a three-dimensional spatial domain. For example, the grid 710 may be a three-dimensional grid that extends in another lateral direction and the grid 720 may be a three-dimensional grid that also extends in that other lateral direction.

As an example, the following equation may be used in a finite element approach:

$$u(\mathbf{x}) \approx \sum_{k=1}^{n} u_k N_k(\mathbf{x})$$

an unknown $u$ is given as a function of spatial location $\mathbf{x}$ = $(x, y, z)^T$ and where $n$ is a total number of grid points or nodes (e.g., for nodes $k = 1$ to $n$) in a spatial domain. In the foregoing equation, $N_k(\mathbf{x})$ may be represented using shape functions $N_i^e$ for each element $e$ such that following equation may be presented for u(x):

$$u(\mathbf{x}) \approx \sum_e \sum_{i=1}^{p^e} u_i N_i^e(\mathbf{x})$$

where the first sum is for a total number of elements, $p^e$ is the number of nodes of each element e and i is a numbering of nodes inside each element.

The foregoing equations are presented as examples of how number of grid points that define nodes for a total number of finite elements may impact the number of equations, computations, etc. In turn, a solution procedure may experience an increase in size of one or more matrices, which can increase computational demands. Again, the foregoing equations pertain to a three-dimensional spatial domain where time may be considered using, for example, a finite difference approach. The foregoing equations may be applied to a two-dimensional spatial domain, for example, with respect to coordinates: *x,y; y,z* or *x,z.*

As an example, to solve a system of partial differential equations, boundary conditions may be specified (e.g., Dirichlet, Neumann, Robin, etc.). Where a grid is coarsened, boundary conditions may be applied to the coarsened grid. As an example, such boundary conditions may be specified as part of a given model, for example, where an optimization procedure is to be performed using that model to enhance understanding of porosity, etc.

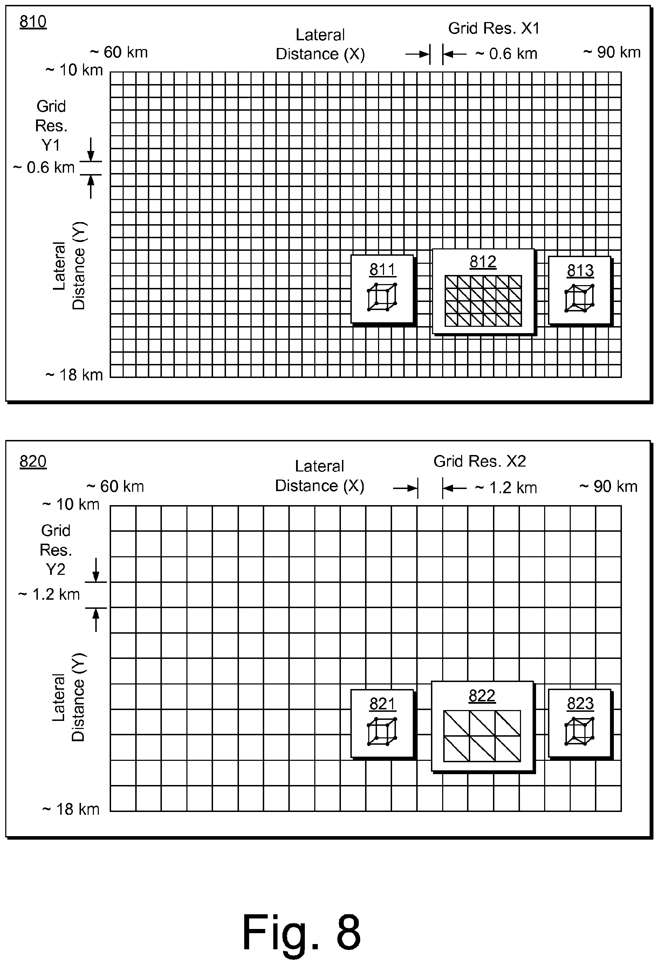

Fig. 8 shows an example of a grid 810 with a fine grid resolution along lateral directions and an example of a grid 820 with a coarser grid resolution along the lateral directions. In the examples of Fig. 8, the grid resolutions in X and Y lateral directions are approximately 0.6 km for the fine grid 810 and approximately 1.2 km for the coarse grid 820. In essence, a coarsening process acts to coarsen four finite elements in the grid 810 to a single finite element in the grid 820. As the grids 810 and 820 also extend along a depth (e.g., a vertical direction), the coarsening acts to reduce the total number of finite elements in an entire volume modeled by the finite elements. For example, the grids 710 and 720 of Fig. 7 may correspond to slices through the lateral grids 810 and 820 of Fig. 8. As shown in insets 811 and 821, for example, an element may be defined by eight nodes of a grid.

As an example, finite elements may be triangular as defined with respect to two lateral dimensions, for example, an inset 812 shows triangular finite elements for a fine lateral grid resolution while an inset 822 shows triangular finite elements for a coarse lateral grid resolution. As an example, a three-dimensional grid may define cubic, tetrahedral or other shaped finite elements suitable for filling a three-dimensional spatial domain. As shown in insets 813 and 823, for example, an element may be defined by six nodes of a grid.

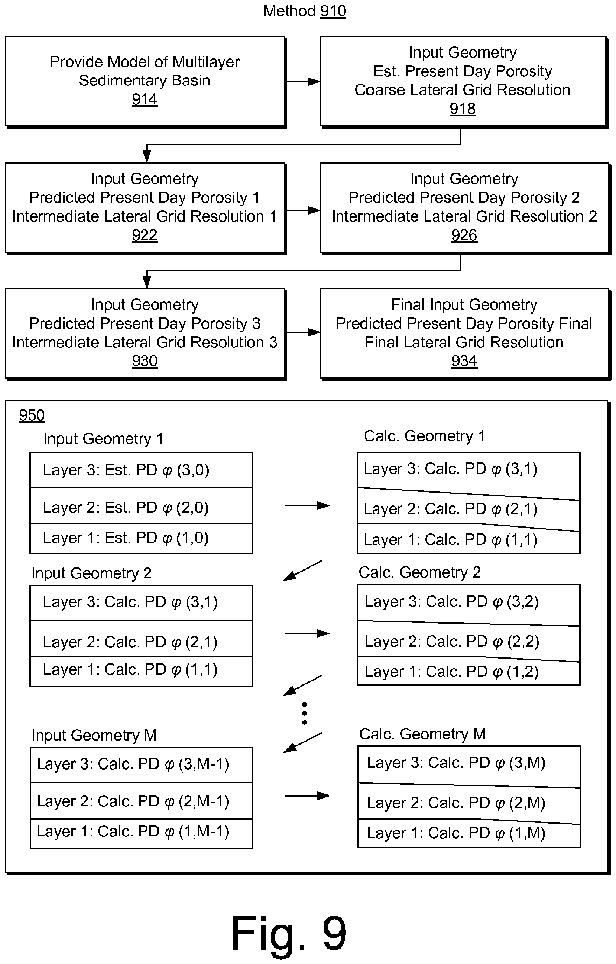

Fig. 9 shows an example of a method 910 as a block diagram along with a process 950 with respect to various layers. The method 910 includes a provision block 914 for providing a model of a multilayer sedimentary basin, an input block 918 for inputting geometry and estimates of present day porosity for a coarse lateral grid resolution for performing a first backstripping and forward simulation cycle, an input block 922 for inputting geometry and predicted present day porosity that result from the first backstripping and forward simulation cycle for performing a second backstripping and forward simulation cycle using an intermediate lateral grid resolution (e.g., more refined than the coarse lateral grid resolution), an input block 926 for inputting geometry and predicted present day porosity that result from the second backstripping and forward simulation cycle for performing a third backstripping and forward simulation cycle using another intermediate lateral grid resolution (e.g., more refined than the prior intermediate lateral grid resolution), and a final input block 934 for inputting geometry and predicted present day porosity that result from the third backstripping and forward simulation cycle for performing a final backstripping and forward simulation cycle using a final lateral grid resolution (e.g., more refined than the prior intermediate lateral grid resolution), for example, to provide predicted present day porosity.

As to the process 950, various layers and present day porosities are shown for each layer using a layer index (e.g., 1, 2 and 3) and a cycle index ranging from start "0" to a final cycle "M". As indicated, for the process 950, the starting present day porosities for each layer are given as estimates whereas for cycles 1 to M, the present day porosities for each layer are calculated values (e.g., which may also be referred to as predicted values).

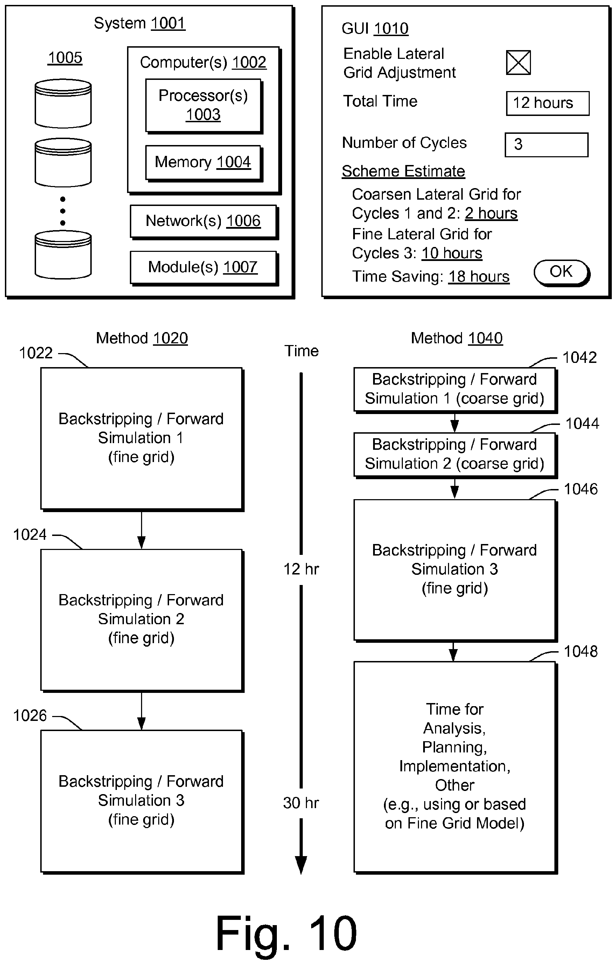

Fig. 10 shows an example of a system 1001, an example of a graphical user interface (GUI) 1010 and examples of methods 1020 and 1040. As shown in Fig. 10, the system 1001 includes one or more computers 1002, one or more storage devices 1005, one or more networks 1006 and one or more modules 1007. As to the one or more computers 1002, each computer may include one or more processors (e.g., or processing cores) 1003 and memory 1004 for storing instructions (e.g., modules), for example, executable by at least one of the one or more processors. As an example, a computer may include one or more network interfaces (e.g., wired or wireless), one or more graphics cards, a display interface (e.g., wired or wireless), etc. As an example, data may be provided in the storage device(s) 1005 where the computer(s) 1002 may access the data via the network(s) 1006 and process the data via the module(s) 1007, for example, as stored in the memory 1004 and executed by the processor(s) 1003.

As an example, the system 1001 may optionally be configured for parallel processing. In such an example, a method that includes grid coarsening may act to control the number of processors implemented to perform the method. For example, if such a method commences with a coarse grid, a certain number of processors may be implemented where that number increases as grid refinement occurs. As an example, some amount of time saving may be realized by processing a coarse grid even where parallel processing is implemented.

As shown in Fig. 10, the GUI 1010 includes a control for enabling a lateral grid adjustment technique. Where such an option is selected, the GUI 1010 includes a control for receipt of a total time as well as a control for a total number of backstripping and forward simulation cycles. In turn, the GUI 1010 may provide a scheme estimate, which may indicate a time saving, for example, in comparison to the same number of cycles without lateral grid adjustment being enabled. For example, where a user wants to perform an optimization procedure in 12 hours with three cycles, the GUI 1010 may receive such information and determine a scheme estimate indicating that cycles 1 and 2 will be performed with a coarsened grid and take about 2 hours of processing time while a final cycle will be performed with a refined grid and take about 10 hours of processing time. In comparison to three cycles being performed with a grid resolution of the refined grid, the amount of time saved is indicated as being about 18 hours. In the example of Fig. 10, the GUI 1010 includes an "OK" control, which may be selected to commence an optimization procedure that uses a coarse grid (e.g., for one or more non-final cycles) and a refined grid (e.g., for a final cycle).

The methods 1020 and 1040 correspond to the example presented for the GUI 1010 of Fig. 10 where the method 1020 includes three cycles 1022, 1024 and 1026 with a fine grid and where the method 1040 includes two cycles with a coarse grid 1042 and 1044, a cycle with a fine grid 1046 and a block 1048 for performing one or more actions, for example, in a saved amount of time that would not be available using the method 1020.

In the invention, a system (see, e.g., the system 1001) includes a processor; memory operatively coupled to the processor; one or more modules stored (or storable) in the memory where the one or more modules include instructions executable by the processor to instruct the system to perform a method of any of claims 1-10. As an example, such one or more modules may include one or more modules of the method 500 of Fig. 5 (see, e.g., the modules 511, 521, 531, 541 and 551), the method 600 of Fig. 6 (see, e.g., the modules 611, 621, 631, 641, 651, 661, 671, 681 and 691), etc.

In an embodiment, the system can include one or more modules with instructions executable by a processor to instruct the system to render to a display a graphical user interface that includes a graphical control to enable instructions to coarsen a finite element grid with respect to a lateral coordinate axis to provide the coarsened finite element grid, for example, for further processing.

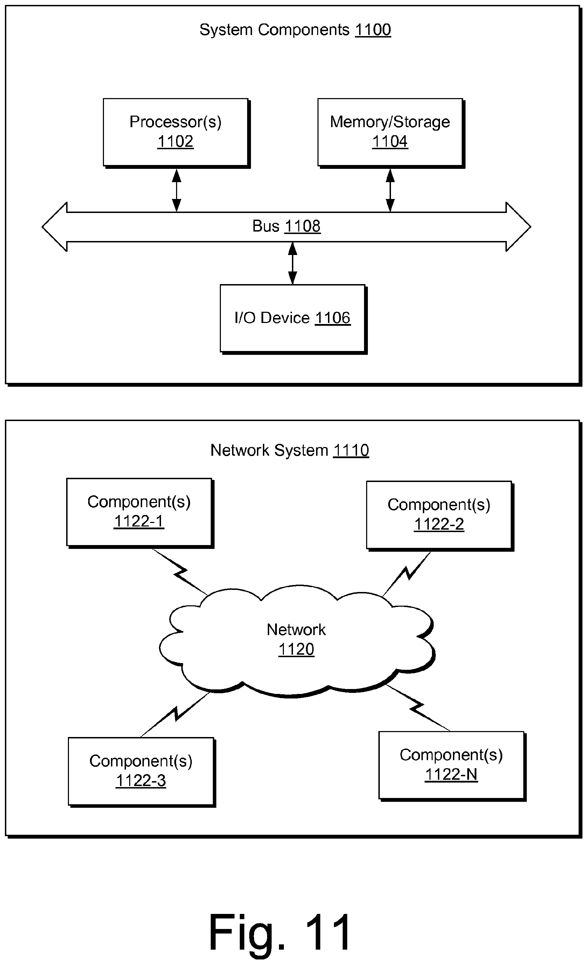

Fig. 11 shows components of an example of a computing system 1100 and an example of a networked system 1110. The system 1100 includes one or more processors 1102, memory and/or storage components 1104, one or more input and/or output devices 1106 and a bus 1108. In an example not forming part of the invention, instructions may be stored in one or more computer-readable media (e.g., memory/storage components 1104). Such instructions may be read by one or more processors (e.g., the processor(s) 1102) via a communication bus (e.g., the bus 1108), which may be wired or wireless. The one or more processors may execute such instructions to implement (wholly or in part) one or more attributes (e.g., as part of a method). A user may view output from and interact with a process via an I/O device (e.g., the device 1106). In an example not forming part of the invention, a computer-readable medium may be a storage component such as a physical memory storage device, for example, a chip, a chip on a package, a memory card, etc.

In an example not forming part of the invention, components may be distributed, such as in the network system 1110. The network system 1110 includes components 1122-1, 1122-2, 1122-3, ... 1122-N. For example, the components 1122-1 may include the processor(s) 1102 while the component(s) 1122-3 may include memory accessible by the processor(s) 1102. Further, the component(s) 1102-2 may include an I/O device for display and optionally interaction with a method. The network may be or include the Internet, an intranet, a cellular network, a satellite network, etc.

As an example, a device may be a mobile device that includes one or more network interfaces for communication of information. For example, a mobile device may include a wireless network interface (e.g., operable via IEEE 802.11, ETSI GSM, BLUETOOTH®, satellite, etc.). As an example, a mobile device may include components such as a main processor, memory, a display, display graphics circuitry (e.g., optionally including touch and gesture circuitry), a SIM slot, audio/video circuitry, motion processing circuitry (e.g., accelerometer, gyroscope), wireless LAN circuitry, smart card circuitry, transmitter circuitry, GPS circuitry, and a battery. As an example, a mobile device may be configured as a cell phone, a tablet, etc. As an example, a method may be implemented (e.g., wholly or in part) using a mobile device. As an example, a system may include one or more mobile devices.

As an example, a system may be a distributed environment, for example, a so-called "cloud" environment where various devices, components, etc. interact for purposes of data storage, communications, computing, etc. As an example, a device or a system may include one or more components for communication of information via one or more of the Internet (e.g., where communication occurs via one or more Internet protocols), a cellular network, a satellite network, etc. As an example, a method may be implemented in a distributed environment (e.g., wholly or in part as a cloud-based service).

As an example, information may be input from a display (e.g., consider a touchscreen), output to a display or both. As an example, information may be output to a projector, a laser device, a printer, etc. such that the information may be viewed. As an example, information may be output stereographically or holographically. As to a printer, consider a 2D or a 3D printer. As an example, a 3D printer may include one or more substances that can be output to construct a 3D object. For example, data may be provided to a 3D printer to construct a 3D representation of a subterranean formation. As an example, layers may be constructed in 3D (e.g., horizons, etc.), geobodies constructed in 3D, etc. As an example, holes, fractures, etc., may be constructed in 3D (e.g., as positive structures, as negative structures, etc.).

Conclusion

Although various methods, devices, systems, have been described in language specific to structural features and/or methodological acts, it is to be understood that the subject matter defined in the appended claims is not necessarily limited to the specific features or acts described. Rather, the specific features and acts are disclosed as examples of forms of implementing the claimed methods and systems. The invention is defined by the appended claims.

**Claims**

1. A computer-implemented method to iteratively model present day geometry of a multilayer sedimentary basin comprising:

    providing a finite element model of a multilayer sedimentary basin represented on a finite element grid described with respect to a lateral coordinate axis and a depth coordinate axis wherein the finite element grid comprises a lateral grid resolution and a depth grid resolution (510);
    coarsening the finite element grid with respect to the lateral coordinate axis to provide a coarsened finite element grid that comprises the depth grid resolution (520);
    performing a backstripping and forward simulation cycle using the coarsened finite element grid to provide present day geometry and porosity results for the model of the multilayer sedimentary basin (530);
    refining the coarsened finite element grid with respect to the lateral coordinate axis to provide a refined finite element grid that comprises the lateral grid resolution and the depth grid resolution (540);
    performing backstripping and forward simulation cycle using the refined finite element grid and at least the porosity results to provide enhanced present day geometry and porosity results for the model of the multilayer sedimentary basin (550); and
    repeating the refining of the finite element grid with respect to the lateral coordinate axis to provide a more refined finite element grid; and performing the backstripping and forward simulation cycle using the more refined finite element grid and at least the enhanced porosity results to provide further enhanced present day geometry and porosity results for the model of the multilayer sedimentary basin.

2. The method of claim 1, wherein the backstripping and forward simulation cycle comprises decompacting a layer of the model of the multilayer sedimentary basin.

3. The method of claim 2, wherein the decompacting comprises estimating a present day porosity for the layer and decompacting the layer to a depositional porosity for the layer.

4. The method of claim 3, wherein the present day porosity for the layer corresponds to a present day thickness for the layer and the depositional porosity for the layer corresponds to a depositional thickness for the layer.

5. The method of claim 1, comprising assessing variation of porosity for a layer of the model of the multilayer sedimentary basin and performing the coarsening of the finite element grid with respect to the lateral coordinate axis based at least in part on the assessing variation of porosity for the layer.

6. The method of claim 1, wherein the providing a finite element grid provides the finite element grid to define N finite elements and wherein the coarsening provides the coarsened finite element grid to define N/2 finite elements.

7. The method of claim 6, wherein the refining provides a refined finite element grid to define N finite elements.

8. The method of claim 1, wherein the providing a finite element grid provides the finite element grid to define N finite elements and wherein the coarsening provides the coarsened finite element grid to define N/4 finite elements.

9. The method of claim 8, wherein the refining provides a refined finite element grid to define N finite elements.

10. The method of claim 1, wherein the providing a finite element grid provides a three-dimensional finite element grid described with respect to the lateral coordinate axis, another lateral coordinate axis and the depth coordinate axis.

11. A system (1001) comprising:

a processor (1003);
memory (1004) operatively coupled to the processor;

processor-executable instructions (1007) stored in the memory executable by the processor to instruct the system to perform a method of any one of the preceding claims.

12. The system of claim 11, wherein the instructions comprise instructions executable by the processor to instruct the system to render to a display a graphical user interface that comprises a graphical control to enable the instructions to coarsen the finite element grid with respect to the lateral coordinate axis to provide the coarsened finite element grid.

**Patentansprüche**

1. Rechnerimplementiertes Verfahren zum iterativen Modellieren einer heutigen Geometrie eines mehrschichtigen Sedimentbeckens, umfassend:

Bereitstellen eines Finite-Elemente-Modells eines mehrschichtigen Sedimentbeckens, das auf einem in Bezug auf eine Lateralkoordinatenachse und eine Tiefenkoordinatenachse beschriebenen Finite-Elemente-Grid dargestellt wird, wobei das Finite-Elemente-Grid eine Grid-Lateralauflösung und eine Grid-Tiefenauflösung umfasst (510);
Vergröbern des Finite-Elemente-Grids in Bezug auf die Lateralkoordinatenachse, um ein vergröbertes Finite-Elemente-Grid bereitzustellen, das die Grid-Tiefenauflösung umfasst (520);
Durchführen eines "Backstripping"- und Vorwärtssimulationszyklus unter Verwendung des vergröberten Finite-Elemente-Grids, um heutige Geometrie- und Porositätsresultate für das Modell des mehrschichtigen Sedimentbeckens bereitzustellen (530);
Verfeinern des vergröberten Finite-Elemente-Grids in Bezug auf die Lateralkoordinatenachse, um ein verfeinertes Finite-Elemente-Grid bereitzustellen, das die Grid-Lateralauflösung und die Grid-Tiefenauflösung umfasst (540);
Durchführen eines "Backstripping"- und Vorwärtssimulationszyklus unter Verwendung des verfeinerten Finite-Elemente-Grids und zumindest der Porositätsresultate, um verbesserte heutige Geometrie- und Porositätsresultate für das Modell des mehrschichtigen Sedimentbeckens bereitzustellen (550); und
Wiederholen des Verfeinerns des Finite-Elemente-Grids in Bezug auf die Lateralkoordinatenachse, um ein weiter verfeinertes Finite-Elemente-Grid bereitzustellen; und
Durchführen des "Backstripping"- und Vorwärtssimulationszyklus unter Verwendung des weiter verfeinerten Finite-Elemente-Grids und zumindest der verbesserten Porositätsresultate, um weiter verbesserte heutige Geometrie- und Porositätsresultate für das Modell des mehrschichtigen Sedimentbeckens bereitzustellen.

2. Verfahren nach Anspruch 1, wobei der "Backstripping"- und Vorwärtssimulationszyklus ein Dekompaktieren einer Schicht des Modells des mehrschichtigen Sedimentbeckens umfasst.

3. Verfahren nach Anspruch 2, wobei das Dekompaktieren ein Schätzen einer heutigen Porosität für die Schicht und Dekompaktieren der Schicht auf eine primäre Porosität für die Schicht umfasst.

4. Verfahren nach Anspruch 3, wobei die heutige Porosität für die Schicht einer heutigen Mächtigkeit für die Schicht entspricht und die primäre Porosität für die Schicht einer primären Mächtigkeit für die Schicht entspricht.

5. Verfahren nach Anspruch 1, umfassend ein Bewerten einer Porositätsvariation für eine Schicht des Modells des mehrschichtigen Sedimentbeckens und Durchführen der Vergröberung des Finite-Elemente-Grids in Bezug auf die Lateralkoordinatenachse, basierend zumindest teilweise auf dem Bewerten der Porositätsvariation für die Schicht.

6. Verfahren nach Anspruch 1, wobei das Bereitstellen eines Finite-Elemente-Grids das Finite-Elemente-Grid bereitstellt, um N finite Elemente zu definieren, und wobei das Vergröbern das vergröberte Finite-Elemente-Grid bereitstellt, um N / 2 finite Elemente zu definieren.

7. Verfahren nach Anspruch 6, wobei das Verfeinern ein verfeinertes Finite-Elemente-Grid bereitstellt, um N finite Elemente bereitzustellen.

8. Verfahren nach Anspruch 1, wobei das Bereitstellen eines Finite-Elemente-Grids das Finite-Elemente-Grid bereitstellt, um N finite Elemente zu definieren, und wobei das Vergröbern das vergröberte Finite-Elemente-Grid bereitstellt, um N / 4 finite Elemente zu definieren.

9. Verfahren nach Anspruch 8, wobei das Verfeinern ein verfeinertes Finite-Elemente-Grid bereitstellt, um N finite Elemente bereitzustellen.

10. Verfahren nach Anspruch 1, wobei das Bereitstellen eines Finite-Elemente-Grids ein in Bezug auf die Lateralkoordinatenachse, eine weitere Lateralkoordinatenachse und die Tiefenkoordinatenachse beschriebenes dreidimensionales Finite-Elemente-Grid bereitstellt.

11. System (1001), umfassend:

einen Prozessor (1003);
einen mit dem Prozessor wirkgekoppelten Speicher (1004);

im Speicher gespeicherte, prozessorausführbare Anweisungen (1007), die vom Prozessor ausführbar sind, um das System anzuweisen, ein Verfahren nach einem der vorhergehenden Ansprüche auszuführen.

12. System nach Anspruch 11, wobei die Anweisungen Anweisungen umfassen, die vom Prozessor ausführbar sind, um das System anzuweisen, eine grafische Benutzeroberfläche, die eine grafische Steuerung umfasst, um zu ermöglichen, dass die Anweisungen das Finite-Elemente-Grid in Bezug auf die Lateralkoordinatenachse vergröbern, um das vergröberte Finite-Elemente-Grid bereitzustellen, auf eine Anzeige zu rendern.

**Revendications**

1. Procédé mis en œuvre par ordinateur pour modéliser de manière itérative la géométrie actuelle d'un bassin sédimentaire multicouche comprenant :

la fourniture d'un modèle d'éléments finis d'un bassin sédimentaire multicouche représenté sur une grille d'éléments finis décrite par rapport à un axe de coordonnées latérales et un axe de coordonnées de profondeur dans lequel la grille d'éléments finis comprend une résolution de grille latérale et une résolution de grille de profondeur (510) ;
la granocroissance de la grille d'éléments finis par rapport à l'axe des coordonnées latérales afin de fournir une grille d'éléments finis grossière qui comprend la résolution de grille de profondeur (520) ;
la réalisation d'un cycle de simulation avant et arrière à l'aide de la grille d'éléments finis grossière afin de fournir la géométrie actuelle et les résultats actuels de porosité destinés au modèle du bassin sédimentaire multicouche (530) ;

l'affinage de la grille d'éléments finis grossière par rapport à l'axe de coordonnées latérales afin de fournir une grille d'éléments finis raffinée qui comprend la résolution de la grille latérale et la résolution de la grille de profondeur (540) ;
la réalisation d'un cycle de simulation avant et arrière à l'aide de la grille d'éléments finis affinée et d'au moins les résultats de porosité afin de fournir une géométrie actuelle améliorée et des résultats de porosité destinés au modèle du bassin sédimentaire multicouche (550) ; et
la répétition de l'affinage de la grille d'éléments finis par rapport à l'axe des coordonnées latérales afin de fournir une grille d'éléments finis plus raffinée ; et
la réalisation du cycle d'extraction et de simulation directe à l'aide de la grille d'éléments finis plus affinée et au moins des résultats de porosité améliorée afin de fournir la géométrie actuelle davantage améliorée et des résultats de porosité destinés au modèle du bassin sédimentaire multicouche.

2. Procédé selon la revendication 1, dans lequel le cycle d'extraction et de simulation directe comprend le décompactage d'une couche du modèle du bassin sédimentaire multicouche.

3. Procédé selon la revendication 2, dans lequel le décompactage comprend l'estimation d'une porosité actuelle pour la couche et à décompacter la couche en porosité de dépôt pour la couche.

4. Procédé selon la revendication 3, dans lequel la porosité actuelle de la couche correspond à une épaisseur actuelle de la couche et la porosité de dépôt de la couche correspond à une épaisseur de dépôt de la couche.

5. Procédé selon la revendication 1, comprenant l'évaluation de la variation de porosité pour une couche du modèle du bassin sédimentaire multicouche et la réalisation de la granocroissance de la grille d'éléments finis par rapport à l'axe de coordonnées latérales basé au moins en partie sur l'évaluation de la variation de porosité pour la couche.

6. Procédé selon la revendication 1, dans lequel la fourniture d'une grille d'éléments finis fournit la grille d'éléments finis pour définir N éléments finis et dans lequel la granocroissance fournit la grille d'éléments finis grossière pour définir N/2 éléments finis.

7. Procédé selon la revendication 6, dans lequel le raffinage fournit une grille d'éléments finis affinée pour définir N éléments finis.

8. Procédé selon la revendication 1, dans lequel la fourniture d'une grille d'éléments finis fournit la grille d'éléments finis pour définir N éléments finis et dans lequel la granocroissance fournit la grille d'éléments finis grossière pour définir N/4 éléments finis.

9. Procédé selon la revendication 8, dans lequel le raffinage fournit une grille d'éléments finis affinée pour définir N éléments finis.

10. Procédé selon la revendication 1, dans lequel la fourniture d'une grille d'éléments finis fournit une grille d'éléments finis tridimensionnelle décrite par rapport à l'axe de coordonnées latéral, un autre axe de coordonnées latéral et l'axe de coordonnées de profondeur.

11. Système (1001) comprenant :

un processeur (1003) ;
une mémoire (1004) couplée de manière fonctionnelle au processeur ;
des instructions exécutables par un processeur (1007) mémorisées dans la mémoire exécutables par le processeur pour ordonner au système d'effectuer un procédé selon l'une quelconque des revendications 1 à 9.

12. Système selon la revendication 11, dans lequel les instructions comprennent des instructions exécutables par le processeur pour ordonner au système de présenter sur un écran une interface utilisateur graphique qui comprend une commande graphique pour permettre aux instructions de rendre grossière la grille d'éléments finis par rapport à l'axe de coordonnées latérales afin de fournir la grille d'éléments finis grossière.

System 100

Management Components 110

| Seismic Data 112 | Other Information 114 |

Processing 116

| Entities 122 | Simulation 120 | Attribute 130 |

| Analysis/ Visualization 142 | Other Workflow 144 |

160

Framework 170

Modules 175

Model Simulation 180

Framework Services 190

Framework Core 195

| Domain Objects 182 |
| Data Source 184 |
| Rendering 186 |
| User Interfaces 188 |

Geologic Environment 150
(e.g., sensing, drilling, injecting, extracting, etc.)

155

156

152

0
1000
2000
3000
4000
5000

154

Fig. 1

Fig. 2

Equations 300

| | |
|---|---|
| Mechanical Compaction 312 | $\dfrac{\partial \varphi}{\partial t} = -C \dfrac{\partial(u_l - u)}{\partial t}$ |

Chemical Compaction 314 $\dfrac{\partial \varphi}{\partial t} = -f_c(T, \sigma')$

Compaction/ Pressure 316

$$\dfrac{C}{1-\varphi}\dfrac{\partial u}{\partial t} - \nabla \cdot \dfrac{k}{v} \cdot \nabla u = \dfrac{C}{1-\varphi}\dfrac{\partial u_l}{\partial t}$$

Heat Transfer 332

$$\dfrac{\partial \lambda_{x,y}}{\partial x}\dfrac{\partial T}{\partial y} - \rho c \dfrac{\partial T}{\partial t} = \rho c \dfrac{\partial(v_x T)}{\partial x} + Q$$

Velocity 334

$$v_x = -\left(\dfrac{k_{x,y}}{v}\right)\dfrac{\partial u}{\partial x}$$

Hydrocarbon Generation 352

$$r = \dfrac{\partial m}{\partial t} = k_r(m_0 - m)$$

Arrhenius Rate 354

$$k_r = Ae^{-\left(E_a/RT\right)}$$

Flow/Migration 370

$$\dfrac{\rho_w \varphi}{1-\varphi}\dfrac{\partial S_w}{\partial t} - \nabla \cdot \rho_w \mu_w \cdot \nabla u_w = \dfrac{\rho_w S_w C}{1-\varphi}\dfrac{\partial(u_l - u_w)}{\partial t} = q_w$$

$$\dfrac{\rho_o \varphi}{1-\varphi}\dfrac{\partial S_o}{\partial t} - \nabla \cdot \rho_o \mu_o \cdot \nabla u_o = \dfrac{\rho_o S_o C}{1-\varphi}\dfrac{\partial(u_l - u_o)}{\partial t} = q_o$$

$$\dfrac{\rho_g \varphi}{1-\varphi}\dfrac{\partial S_g}{\partial t} - \nabla \cdot \rho_g \mu_g \cdot \nabla u_g = \dfrac{\rho_g S_g C}{1-\varphi}\dfrac{\partial(u_l - u_g)}{\partial t} = q_g$$

$$S_w + S_o + S_g = 1$$

$$u_o - u_w = p_{co}(S_w) + (\rho_w - \rho_o)Gz$$

$$u_g - u_o = p_{cg}(S_o) + (\rho_o - \rho_g)Gz$$

# Fig. 3

T0    T1    T2    T3    T4    410

412

Basement

Equation 420

$$d_0 (1 - \varphi_0)$$

$$= d_p (1 - \varphi_p)$$

414

• Basement

Thickness (depth to basement)

With Compaction

$d_0$ depositional thickness

$d_p$ present day thickness

$\varphi_0$ depositional porosity

$\varphi_p$ present day porosity

Time

Paleo Time    Paleo Time    Present Day    440

442    444    446

454    456    458

Est. Initial Thickness

Est.

Porosity Thickness

Overburden Lithostatic Pressure

Estimated Steady-State Porosity

Calc.

Calc.    Given    452

Fig. 4

Method 500

Provide a finite element grid described
with respect to a lateral coordinate axis and a depth coordinate axis
to model a multilayer sedimentary basin
510

511

Coarsen the finite element grid
with respect to the lateral coordinate axis
to provide a coarsened finite element grid
520

521

Perform a backstripping and forward simulation cycle
using the coarsened finite element grid to provide geometry and
porosity results for the model of the multilayer sedimentary basin
530

531

Optionally Repeat Block 530 using the Coarsened Finite
Element Grid or Another Coarsened Finite Element Grid

Refine the finite element grid
with respect to the lateral coordinate axis
to provide a refined finite element grid
540

541

Perform another backstripping and forward simulation cycle
using the refined finite element grid and at least the porosity results
to provide enhanced geometry and porosity results
for the model of the multilayer sedimentary basin
550

551

# Fig. 5

Method 600

Provide Finite Element Model of Sedimentary (Layered) Basin
for Lateral Grid Resolution X1
610

611

Provide Estimates of Present Day Porosity ($\varphi_p$) for Each Layer
for Lateral Grid Resolution X2 (X1 finer than X2)
620

621

Decompact Layers for Lateral Grid Resolution X2
630

631

Simulate Pore Pressure Controlled Compaction of Layers
for Lateral Grid Resolution X2 for Calculated Present Day Geometry
640

641

Error

Iterations

Other

650

OK?

651

No

Yes

Update Estimates of
Present Day Porosity
($\varphi_p$) for Each Layer
660

661

Update Estimates of Present Day Porosity ($\varphi_p$) for Each Layer
for Lateral Grid Resolution X1 (e.g., with interpolation)
670

671

Decompact Layers for Lateral Grid Resolution X1
680

681

Simulate Pore Pressure Controlled Compaction of Layers
for Lateral Grid Resolution X1 for Calculated Present Day Geometry
690

691

# Fig. 6

Fig. 7

Fig. 8

Method 910

| Provide Model of Multilayer Sedimentary Basin 914 | Input Geometry Est. Present Day Porosity Coarse Lateral Grid Resolution 918 |
|---|---|

| Input Geometry Predicted Present Day Porosity 1 Intermediate Lateral Grid Resolution 1 922 | Input Geometry Predicted Present Day Porosity 2 Intermediate Lateral Grid Resolution 2 926 |
|---|---|

| Input Geometry Predicted Present Day Porosity 3 Intermediate Lateral Grid Resolution 3 930 | Final Input Geometry Predicted Present Day Porosity Final Final Lateral Grid Resolution 934 |
|---|---|

950

Input Geometry 1

| Layer 3: Est. PD $\varphi$ (3,0) |
| Layer 2: Est. PD $\varphi$ (2,0) |
| Layer 1: Est. PD $\varphi$ (1,0) |

Calc. Geometry 1

| Layer 3: Calc. PD $\varphi$ (3,1) |
| Layer 2: Calc. PD $\varphi$ (2,1) |
| Layer 1: Calc. PD $\varphi$ (1,1) |

Input Geometry 2

| Layer 3: Calc. PD $\varphi$ (3,1) |
| Layer 2: Calc. PD $\varphi$ (2,1) |
| Layer 1: Calc. PD $\varphi$ (1,1) |

Calc. Geometry 2

| Layer 3: Calc. PD $\varphi$ (3,2) |
| Layer 2: Calc. PD $\varphi$ (2,2) |
| Layer 1: Calc. PD $\varphi$ (1,2) |

Input Geometry M

| Layer 3: Calc. PD $\varphi$ (3,M-1) |
| Layer 2: Calc. PD $\varphi$ (2,M-1) |
| Layer 1: Calc. PD $\varphi$ (1,M-1) |

Calc. Geometry M

| Layer 3: Calc. PD $\varphi$ (3,M) |
| Layer 2: Calc. PD $\varphi$ (2,M) |
| Layer 1: Calc. PD $\varphi$ (1,M) |

Fig. 9

**System 1001**

1005

Computer(s) 1002

Processor(s) 1003

Memory 1004

Network(s) 1006

Module(s) 1007

**GUI 1010**

Enable Lateral Grid Adjustment ☒

Total Time | 12 hours |

Number of Cycles | 3 |

Scheme Estimate

Coarsen Lateral Grid for Cycles 1 and 2: 2 hours
Fine Lateral Grid for Cycles 3: 10 hours
Time Saving: 18 hours ⟨ OK ⟩

**Method 1020**

1022 — Backstripping / Forward Simulation 1 (fine grid)

1024 — Backstripping / Forward Simulation 2 (fine grid)

1026 — Backstripping / Forward Simulation 3 (fine grid)

Time

12 hr

30 hr

**Method 1040**

1042 — Backstripping / Forward Simulation 1 (coarse grid)

1044 — Backstripping / Forward Simulation 2 (coarse grid)

1046 — Backstripping / Forward Simulation 3 (fine grid)

1048 — Time for Analysis, Planning, Implementation, Other (e.g., using or based on Fine Grid Model)

# Fig. 10

System Components 1100

Processor(s)
1102

Memory/Storage
1104

Bus 1108

I/O Device 1106

Network System 1110

Component(s)
1122-1

Component(s)
1122-2

Network
1120

Component(s)
1122-3

Component(s)
1122-N

# Fig. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Fundamentals of Basin and Petroleum Systems Modeling. **HANTSCHEL et al.** A commercially available modeling framework marketed as the PETROMOD® framework. Schlumberger Limited, 2009

- **ZIENKIEWICZ ; TAYLOR.** *The Finite Element Method Set,* 1984